# EUROPEAN PATENT APPLICATION

(11) **EP 4 106 026 A1**
(43) Date of publication of application: **21.12.2022**
(21) Application number: 21180322.6
(22) Date of filing: 18.06.2021
(51) Int. Cl.: H01L 51/00, H01L 51/50

(54) **AN ORGANIC ELECTRONIC DEVICE COMPRISING A SUBSTRATE, AN ANODE LAYER, A CATHODE LAYER, AT LEAST ONE FIRST EMISSION LAYER, AND AT LEAST ONE HOLE INJECTION LAYER THAT COMPRISES A METAL COMPLEX**

(71) Applicant: Novaled GmbH, 01099 Dresden (DE)
(72) Inventor: UVAROV, Vladimir, 01099 Dresden (DE); HEGGEMANN, Ulrich, 01099 Dresden (DE); WILLMANN, Steffen, 01099 Dresden (DE); PIERMARIA, Pinter, 01099 Dresden (DE)
(74) Representative: Michalski Hüttermann & Partner Patentanwälte mbB

(57) **Abstract**

The present invention relates to an organic electronic device comprising a substrate, an anode layer, a cathode layer, at least one emission layer, and at least one or more hole injection layers, wherein the hole injection layer is arranged between the anode layer and the at least one emission layer, and wherein the hole injection layer comprises a metal complex.

## Description

### Technical Field

The present invention relates to an organic electronic device comprising a substrate, an anode layer, a cathode layer, at least a first emission layer, and at least one hole injection layer that comprises a metal complex.

### Background Art

Organic electronic devices, such as organic light-emitting diodes OLEDs, which are self-emitting devices, have a wide viewing angle, excellent contrast, quick response, high brightness, excellent operating voltage characteristics, and color reproduction. A typical OLED comprises an anode layer, a hole injection layer HIL, a hole transport layer HTL, an emission layer EML, an electron transport layer ETL, and a cathode layer, which are sequentially stacked on a substrate. In this regard, the HIL, the HTL, the EML, and the ETL are thin films formed from organic compounds.

When a voltage is applied to the anode and the cathode, holes injected from the anode move to the EML, via the HIL and HTL, and electrons injected from the cathode move to the EML, via the ETL. The holes and electrons recombine in the EML to generate excitons. When the excitons drop from an excited state to a ground state, light is emitted. The injection and flow of holes and electrons should be balanced, so that an OLED having the above-described structure has low operating voltage, excellent efficiency and/or a long lifetime.

Performance of an organic light emitting diode may be affected by characteristics of the hole injection layer, and among them, may be affected by characteristics of the hole transport compound and the metal complexes which are contained in the hole injection layer.

WO2017029370 relates to metal amides of general Formula Ia and for their use as hole injection layer (HIL) for an Organic light-emitting diode (OLED), and a method of manufacturing Organic light-emitting diode (OLED) comprising an hole injection layer containing a defined metal amide.

WO2017029366 relates to a hole injection layer for an OLED comprising a triarylamine compound doped with a charge neutral metal amide compound, characterized in that the hole injection layer has a thickness of at least about ≥ 20 nm to about ≤ 1000 nm and a defined charge neutral metal amide compound.

WO2017102861 relates to an organic electronic component comprising at least one organic layer, which has a fluorinated sulphonamide metal salt of the following formula 1: (1) wherein M is either a bivalent or higher-order metal having an atomic mass of greater than 26 g/mol or a monovalent metal having an atomic mass of greater than or equal to 39 g/mol, wherein 1 ≤ n ≤ 7, and wherein R1, R2 are selected independently of each other and from a group comprising a fluoride-substituted aryl radical, a fluoride-substituted alkyl radical, and a fluoride-substituted aryl-alkyl radical.

There remains a need to improve performance of organic electronic devices by providing hole injection layers with improved performance, in particular to achieve improved operating voltage through improving the characteristics of the hole injection layer and the organic electronic device.

Further there remains a need to provide hole injection layers which enable injection into adjacent layers comprising compounds with a HOMO level further away from vacuum level.

It is a further objective to provide a hole injection layer comprising compounds which can be deposited through vacuum thermal evaporation under conditions suitable for mass production.

### DISCLOSURE

An aspect of the present invention provides an organic electronic device comprising a substrate, an anode layer, a cathode layer, at least one emission layer, and at least one or more hole injection layers, wherein the hole injection layer is arranged between the anode layer and the at least one emission layer, and wherein the hole injection layer comprises:
- a metal complex, wherein
   the metal complex has the formula (I):

   M^{n⊕}(L^{Θ})ₘ (I)

   wherein
   - M: is a metal ion;
   - n: is the valency of M;
   - m: is n;
   - L: is a ligand of formula (II) 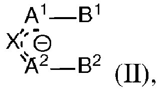
   wherein
   - A¹ and A²: are SO₂;
   - X: is N;
   - B¹ and B²: are independently selected from substituted C₆ to C₁₉ aryl or substituted or unsubstituted C₂ to C₂₀ heteroaryl,
   wherein at least one of the substituents of the substituted C₆ to C₁₉ aryl or substituted C₂ to C₂₀ heteroaryl are independently selected from halogen, Cl, F, CN, partially or perfluorinated C₁ to C₈ alkyl, partially or perfluorinated C₁ to C₈ alkoxy;
   and
- a compound of formulae (III) or (IV): 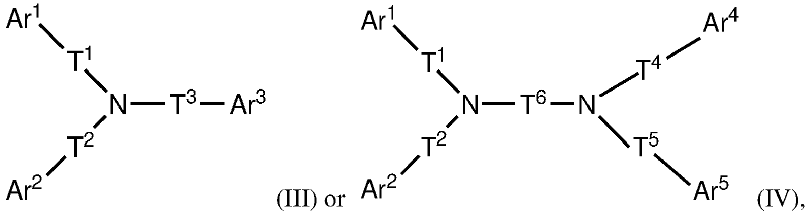 wherein
   - T¹, T², T³, T⁴ and T⁵: are independently selected from a single bond, phenylene, biphenylene, terphenylene or naphthenylene, preferably a single bond or phenylene;
   - T⁶: is selected from substituted or unsubstituted phenylene, biphenylene, terphenylene or naphthenylene; wherein the substituent on phenylene is selected from C₆ to C₁₈ aryl , C₃ to C₁₈ heteroaryl, phenyl, biphenyl, carbazole, phenyl carbazole, preferably biphenyl or 9-phenyl carbazole;
   - Ar¹, Ar², Ar³, Ar⁴ and Ar⁵: are independently selected from substituted or unsubstituted C₆ to C₂₀ aryl, or substituted or unsubstituted C₃ to C₂₀ heteroarylene, substituted or unsubstituted biphenylene, substituted or unsubstituted fluorene, substituted 9-fluorene, substituted 9,9-fluorene, substituted or unsubstituted naphthalene, substituted or unsubstituted anthracene, substituted or unsubstituted phenanthrene, substituted or unsubstituted pyrene, substituted or unsubstituted perylene, substituted or unsubstituted triphenylene, substituted or unsubstituted tetracene, substituted or unsubstituted tetraphene, substituted or unsubstituted dibenzofurane, substituted or unsubstituted dibenzothiophene, substituted or unsubstituted xanthene, substituted or unsubstituted carbazole, substituted 9-phenylcarbazole, substituted or unsubstituted azepine, substituted or unsubstituted dibenzo[b,f]azepine, substituted or unsubstituted 9,9'-spirobi[fluorene], substituted or unsubstituted 9,9'-spirobi[fluorene] with at least one fused aromatic ring, substituted or unsubstituted spiro[fluorene-9,9'-xanthene], a substituted or unsubstituted aromatic fused ring system comprising two aromatic 6-member rings and two aromatic 5-member rings, wherein at least one 5-member ring comprises a hetero atom, a substituted or unsubstituted aromatic fused ring system comprising two aromatic 6-member rings and two aromatic 5-member rings, wherein at least one 5-member ring comprises an O atom, or a substituted or unsubstituted aromatic fused ring system comprising at least three substituted or unsubstituted aromatic rings selected from the group comprising substituted or unsubstituted non-hetero, substituted or unsubstituted hetero 5-member rings, substituted or unsubstituted 6-member rings and/or substituted or unsubstituted 7-member rings, substituted or unsubstituted fluorene, substituted or unsubstituted fluorene with an annelated substitued or unsubstitued hetero or non-hetero ring system comprising 2 to 6 substituted or unsubstituted 5-, 6- or 7-member rings, or a fused ring system comprising 2 to 6 substituted or unsubstituted 5- to 7-member rings and the rings are selected from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle;
   wherein the substituents of Ar¹, Ar², Ar³, Ar⁴ and Ar⁵ are selected the same or different from the group comprising H, D, F, C(=O)R², CN, Si(R²)₃, P(=O)(R²)₂, OR², S(=O)R², S(=O)₂R², substituted or unsubstituted straight-chain alkyl having 1 to 20 carbon atoms, substituted or unsubstituted branched alkyl having 1 to 20 carbon atoms, substituted or unsubstituted cyclic alkyl having 3 to 20 carbon atoms, substituted or unsubstituted alkenyl or alkynyl groups having 2 to 20 carbon atoms, substituted or unsubstituted alkoxy groups having 1 to 20 carbon atoms, substituted or unsubstituted aromatic ring systems having 6 to 40 aromatic ring atoms, and substituted or unsubstituted heteroaromatic ring systems having 5 to 40 aromatic ring atoms, unsubstituted C₆ to C₁₈ aryl, unsubstituted C₃ to C₁₈ heteroaryl, a fused ring system comprising 2 to 6 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle,
   wherein R² is selected from H, D, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, C₆ to C₁₈ aryl or C₃ to C₁₈ heteroaryl;
wherein the compound of formula (III) and (IV) has a calculated HOMO in the range of < -4.79 eV and > 6.5 eV,
when the HOMO is calculated using TURBOMOLE V6.5 (TURBOMOLE GmbH, Litzenhardtstrasse 19, 76135 Karlsruhe, Germany) by applying the hybrid functional B3LYP with a 6-31G* basis set in the gas phase.

It should be noted that the ligand L have a negative charge.

According to one embodiment the negative charge of the Ligand L may correspond to the valency of the metal ion M.

According to one embodiment of the organic electronic device, wherein the following compounds E1 to E5 from the hole injection layer of the organic electronic device may be excluded:

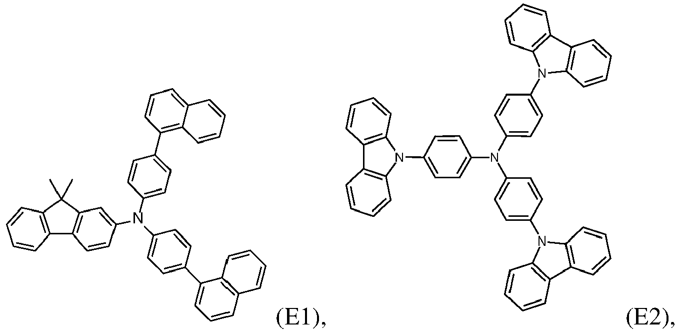

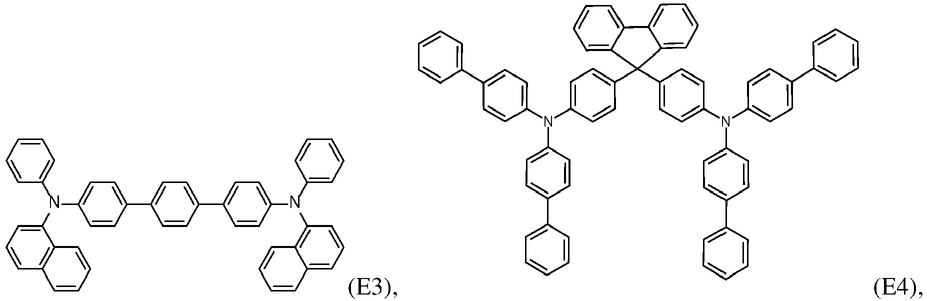

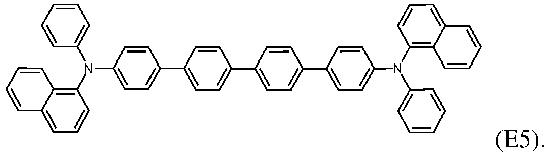

According to one embodiment of the organic electronic device, wherein the following compounds from the hole injection layer of the organic electronic device may be excluded, named by CAS number: 1835250-94-6, 139255-16-6, 174141-92-5, 948552-24-7, 139092-78-7, 1458062-55-9, 2417957-16-3, 2417957-19-6, 58328-31-7, and/or 1643480-23-2.

According to one embodiment of the organic electronic device, wherein the hole injection layer of the organic electronic device can be free of metal phthalocyanine or CuPc, or the layers of the organic electronic device are free of metal phthalocyanine or CuPc. Preferably, the hole injection layer can be free of ionic liquids, metal phthalocyanine, CuPc, HAT-CN, Pyrazino[2,3-f][1,10]phenanthroline-2,3-dicarbonitrile, F4TCNQ, metal fluoride and/or metal oxides, wherein the metal in the metal oxide is selected from Re and/or Mo.

### Definitions

It should be noted that throughout the application and the claims any Aⁿ, Arⁿ, Rⁿ, Tⁿ etc. always refers to the same moieties, unless otherwise noted.

In the present specification, when a definition is not otherwise provided, "substituted" refers to one substituted with a deuterium, C₁ to C₁₂ alkyl and C₁ to C₁₂ alkoxy.

In the present specification, when a definition is not otherwise provided, a substituted aryl group with at least 6 C-ring atoms can be substituted with 1, 2, 3, 4 or 5 substituents. For example, a substituted C₆ aryl group may have 1, 2, 3, 4 or 5 phenyl substituents.

However, in the present specification "aryl substituted" refers to a substitution with one or more aryl groups, which themselves may be substituted with one or more aryl and/or heteroaryl groups.

Correspondingly, in the present specification "heteroaryl substituted" refers to a substitution with one or more heteroaryl groups, which themselves may be substituted with one or more aryl and/or heteroaryl groups.

In the present specification, when a definition is not otherwise provided, a substituted heteroaryl group with at least 2 C-ring atoms can be substituted with one or more substituents. For example, a substituted C₂ heteroaryl group may have 1 or 2 substituents.

In the present specification, when a definition is not otherwise provided, an "alkyl group" refers to a saturated aliphatic hydrocarbyl group. The alkyl group may be a C₁ to C₁₂ alkyl group. More specifically, the alkyl group may be a C₁ to C₁₀ alkyl group or a C₁ to C₆ alkyl group. For example, a C₁ to C₄ alkyl group includes 1 to 4 carbons in alkyl chain, and may be selected from methyl, ethyl, propyl, iso-propyl, n-butyl, iso-butyl, sec-butyl, and tert-butyl.

Specific examples of the alkyl group may be a methyl group, an ethyl group, a propyl group, an iso-propyl group, a butyl group, an iso-butyl group, a sec-butyl group, a tert-butyl group, a pentyl group, a branched pentyl group, a hexyl group.

The term "cycloalkyl" refers to saturated hydrocarbyl groups derived from a cycloalkane by formal abstraction of one hydrogen atom from a ring atom comprised in the corresponding cycloalkane. Examples of the cycloalkyl group may be a cyclopropyl group, a cyclobutyl group, a cyclopentyl group, a cyclohexyl group, a methyl cyclohexyl group, an adamantly group and the like.

The term "hetero" is understood the way that at least one carbon atom, in a structure which may be formed by covalently bound carbon atoms, is replaced by another polyvalent atom. Preferably, the heteroatoms are selected from B, Si, N, P, O, S; more preferably from N, P, O, S.

Preferred examples of the hole transport compounds, which can be covalent hole transport compounds, are organic compounds, consisting or substantially consisting from covalently bound C, H, O, N, S, which may optionally comprise also covalently bound B, P or Si. In one embodiment, the hole transport compounds, which can be a covalent compound, is free of metal atoms and majority of its skeletal atoms may be selected from C, O, S, N. Alternatively, the covalent compound is free of metal atoms and majority of its skeletal atoms may be selected from C and N.

In the present specification, "aryl group" and "aromatic rings" refers to a hydrocarbyl group which can be created by formal abstraction of one hydrogen atom from an aromatic ring in the corresponding aromatic hydrocarbon. Aromatic hydrocarbon refers to a hydrocarbon which contains at least one aromatic ring or aromatic ring system. Aromatic ring or aromatic ring system refers to a planar ring or ring system of covalently bound carbon atoms, wherein the planar ring or ring system comprises a conjugated system of delocalized electrons fulfilling Hückel's rule. Examples of aryl groups include monocyclic groups like phenyl or tolyl, polycyclic groups which comprise more aromatic rings linked by single bonds, like biphenyl, and polycyclic groups comprising fused rings, like naphthyl or fluorenyl.

Analogously, under "heteroaryl" and "heteroaromatic", it is especially where suitable understood a group derived by formal abstraction of one ring hydrogen from a heterocyclic aromatic ring in a compound comprising at least one such ring.

The term "non-heterocycle" is understood to mean a ring or ring-system comprising no hetero-atom as a ring member.

The term "heterocycle" is understood to mean that the heterocycle comprises at least one ring comprising one or more hetero-atoms. A heterocycle comprising more than one ring means that all rings comprising a hetero-atom or at least one ring comprising a hetero atom and at least one ring comprising C-atoms only and no hetero atom.

Under heterocycloalkyl, it is especially where suitable understood a group derived by formal abstraction of one ring hydrogen from a saturated cycloalkyl ring in a compound comprising at least one such ring.

The term "fused aryl rings" or "condensed aryl rings" is understood the way that two aryl rings are considered fused or condensed when they share at least two common sp²-hybridized carbon atoms.

The term "fused ring system" is understood to mean a ring system wherein two or more rings share at least two atoms.

The term "5-, 6- or 7-member ring" is understood to mean a ring comprising 5, 6 or 7 atoms. The atoms may be selected from C and one or more hetero-atoms.

In the present specification, the single bond refers to a direct bond.

In the present specification, when a definition is not otherwise provided, "substituted" refers to one substituted with a H, deuterium, C₁ to C₁₂ alkyl, unsubstituted C₆ to C₁₈ aryl, and unsubstituted C₃ to C₁₈ heteroaryl.

In the present specification, when a substituent is not named, the substituent can be a H.

In the context of the present invention, "different" means that the compounds do not have an identical chemical structure.

The term "free of', "does not contain", "does not comprise" does not exclude impurities which may be present in the compounds prior to deposition. Impurities have no technical effect with respect to the object achieved by the present invention.

The term "contacting sandwiched" refers to an arrangement of three layers whereby the layer in the middle is in direct contact with the two adjacent layers.

The terms "light-absorbing layer" and "light absorption layer" are used synonymously.

The terms "light-emitting layer", "light emission layer" and "emission layer" are used synonymously.

The terms "OLED", "organic light-emitting diode" and "organic light-emitting device" are used synonymously.

The terms anode, anode layer and anode electrode are used synonymously.

The term "at least two anode sub-layers" is understood to mean two or more anode sub-layers, for example two or three anode sub-layers. The terms cathode, cathode layer and cathode electrode are used synonymously.

The term "hole injection layer" is understood to mean a layer which improves charge injection from the anode layer into further layers in the organic electronic device or from further layers of the organic electronic device into the anode.

The term "hole transport layer" is understood to mean a layer which transports holes between the hole injection layer and further layers arranged between the hole injection layer and the cathode layer.

The operating voltage U is measured in Volt.

In the context of the present specification the term "essentially non-emissive" or "non-emissive" means that the contribution of the matrix compound of formulae (III) or (IV), metal complex (I) and/or layer, such as hole injection layer, to the visible emission spectrum from an organic electronic device, such as OLED or display device, is less than 10 %, preferably less than 5 % relative to the visible emission spectrum. The visible emission spectrum is an emission spectrum with a wavelength of about ≥ 380 nm to about ≤ 780 nm.

In the specification, hole characteristics refer to an ability to donate an electron to form a hole when an electric field is applied and that a hole formed in the anode may be easily injected into the emission layer and transported in the emission layer due to conductive characteristics according to a highest occupied molecular orbital (HOMO) level.

In addition, electron characteristics refer to an ability to accept an electron when an electric field is applied and that electrons formed in the cathode may be easily injected into the emission layer and transported in the emission layer due to conductive characteristics according to a lowest unoccupied molecular orbital (LUMO) level.

The term "HOMO level" is understood to mean the highest occupied molecular orbital and is determined in eV (electron volt).

The term "HOMO level further away from vacuum level" is understood to mean that the absolute value of the HOMO level is higher than the absolute value of the HOMO level of the reference compound. For example, the term "further away from vacuum level than the HOMO level N-([1,1'-biphenyl]-4-yl)-9,9-dimethyl-N-(4-(9-phenyl-9H-carbazol-3-yl)phenyl)-9H-fluoren-2-amine is understood to mean that the absolute value of the HOMO level of the hole injection layer is higher than the HOMO level of N-([1,1'-biphenyl]-4-yl)-9,9-dimethyl-N-(4-(9-phenyl-9H-carbazol-3-yl)phenyl)-9H-fluoren-2-amine.

The term "absolute value" is understood to mean the value without the "-" symbol. According to one embodiment of the present invention, the HOMO level of the hole injection layer may be calculated by quantum mechanical methods.

The work function of the first metal is measured in eV (electron volt). Tabulated values of work functions can be found for example in CRC Handbook of Chemistry and Physics version 2008, p. 12-114. Further, tabulated values of work functions can be found for example at https://en.wikipedia.org/wiki/Work_function#cite_note-12.

### Advantageous Effects

Surprisingly, it was found that the organic electronic device according to the invention solves the problem underlying the present invention by enabling organic electronic devices, such as organic light-emitting diodes, in various aspects superior over the organic electronic devices known in the art, in particular with respect to operating voltage, efficiency and/or voltage stability over time.

### Further embodiments

Additionally, it was found that the problem underlying the present invention can be solved by providing compounds which may be suitable for deposition through vacuum thermal evaporation under conditions suitable for mass production. In particular, the rate onset temperature of the metal complex of the present invention may be in a range suitable for mass production.

According to another embodiment the organic electronic device comprising a substrate, an anode layer comprising at least three anode sublayers, a cathode layer, at least one first emission layer, and a hole injection layer, wherein the hole injection layer comprises:
- a metal complex, wherein the metal complex has the formula (I):

   M^{n⊕}(L^{Θ})ₘ (I),

   wherein
   - M: is a metal ion,
   - n: is the valency of M and is an integer from 1 to 4,
   - m: is n,
   - L: is a ligand of formula (II) 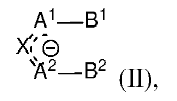
   wherein
   - A¹ and A²: are SO₂;
   - X: is N;
   - B¹ and B²: are independently selected from substituted C₆ to C₁₉ aryl or substituted or unsubstituted C₂ to C₂₀ heteroaryl,
   wherein at least one of the substituents of the substituted C₆ to C₁₉ aryl or substituted C₂ to C₂₀ heteroaryl are independently selected from halogen, Cl, F, CN, partially or perfluorinated C₁ to C₈ alkyl, partially or perfluorinated C₁ to C₈ alkoxy; and
   wherein the charge neutral form of M has optional an electro-negativity value according to Allen of less than 2.4;
   and
- a compound of formulae (III) or (IV): 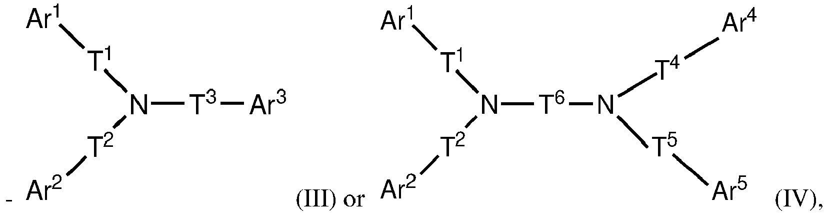 wherein
   - T¹, T², T³, T⁴ and T⁵: are independently selected from a single bond, phenylene, biphenylene, terphenylene or naphthenylene, preferably a single bond or phenylene;
   - T⁶: is selected from substituted or unsubstituted phenylene, biphenylene, terphenylene or naphthenylene; wherein the substituent on phenylene is selected from C₆ to C₁₈ aryl , C₃ to C₁₈ heteroaryl, phenyl, biphenyl, carbazole, phenyl carbazole, preferably biphenyl or 9-phenyl carbazole;
   - Ar¹, Ar², Ar³, Ar⁴ and Ar⁵: are independently selected from substituted or unsubstituted C₆ to C₂₀ aryl, or substituted or unsubstituted C₃ to C₂₀ heteroarylene, substituted or unsubstituted biphenylene, substituted or unsubstituted fluorene, substituted 9-fluorene, substituted 9,9-fluorene, substituted or unsubstituted naphthalene, substituted or unsubstituted anthracene, substituted or unsubstituted phenanthrene, substituted or unsubstituted pyrene, substituted or unsubstituted perylene, substituted or unsubstituted triphenylene, substituted or unsubstituted tetracene, substituted or unsubstituted tetraphene, substituted or unsubstituted dibenzofurane, substituted or unsubstituted dibenzothiophene, substituted or unsubstituted xanthene, substituted or unsubstituted carbazole, substituted 9-phenylcarbazole, substituted or unsubstituted azepine, substituted or unsubstituted dibenzo[b,f]azepine, substituted or unsubstituted 9,9'-spirobi[fluorene], substituted or unsubstituted 9,9'-spirobi[fluorene] with at least one fused aromatic ring, substituted or unsubstituted spiro[fluorene-9,9'-xanthene], a substituted or unsubstituted aromatic fused ring system comprising two aromatic 6-member rings and two aromatic 5-member rings, wherein at least one 5-member ring comprises a hetero atom, a substituted or unsubstituted aromatic fused ring system comprising two aromatic 6-member rings and two aromatic 5-member rings, wherein at least one 5-member ring comprises an O atom, or a substituted or unsubstituted aromatic fused ring system comprising at least three substituted or unsubstituted aromatic rings selected from the group comprising substituted or unsubstituted non-hetero, substituted or unsubstituted hetero 5-member rings, substituted or unsubstituted 6-member rings and/or substituted or unsubstituted 7-member rings, substituted or unsubstituted fluorene, substituted or unsubstituted fluorene with an annelated substitued or unsubstitued hetero or non-hetero ring system comprising 2 to 6 substituted or unsubstituted 5-, 6- or 7-member rings, or a fused ring system comprising 2 to 6 substituted or unsubstituted 5- to 7-member rings and the rings are selected from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle;
   wherein the substituents of Ar¹, Ar², Ar³, Ar⁴ and Ar⁵ are selected the same or different from the group comprising H, D, F, C(=O)R², CN, Si(R²)₃, P(=O)(R²)₂, OR², S(=O)R², S(=O)₂R², substituted or unsubstituted straight-chain alkyl having 1 to 20 carbon atoms, substituted or unsubstituted branched alkyl having 1 to 20 carbon atoms, substituted or unsubstituted cyclic alkyl having 3 to 20 carbon atoms, substituted or unsubstituted alkenyl or alkynyl groups having 2 to 20 carbon atoms, substituted or unsubstituted alkoxy groups having 1 to 20 carbon atoms, substituted or unsubstituted aromatic ring systems having 6 to 40 aromatic ring atoms, and substituted or unsubstituted heteroaromatic ring systems having 5 to 40 aromatic ring atoms, unsubstituted C₆ to C₁₈ aryl, unsubstituted C₃ to C₁₈ heteroaryl, a fused ring system comprising 2 to 6 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle,
   wherein R² is selected from H, D, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, C₆ to C₁₈ aryl or C₃ to C₁₈ heteroaryl;
   wherein the compound of formula (III) and (IV) has a calculated HOMO in the range of < -4.79 eV and > 6.5 eV; and wherein
- the first anode sub-layer comprises a first metal having a work function in the range of ≥ 4 and ≤ 6 eV,
- the second anode sub-layer comprises a transparent conductive oxide (TCO); and
- the third anode sub-layer comprises preferably a transparent conductive oxide, wherein the first anode sub-layer is arranged closer to the substrate and the second anode sub-layer is arranged closer to the hole injection layer; and the third anode sub-layer is arranged between the substrate and the first anode sub-layer.

### Anode layer

The anode layer may be formed by depositing or sputtering a material that is used to form the anode layer. The material used to form the anode layer may be a high work-function material, so as to facilitate hole injection. The anode material may also be selected from a low work function material (i.e. aluminum). The anode electrode may be a transparent or reflective electrode. Transparent conductive oxides, such as indium tin oxide (ITO), indium zinc oxide (IZO), tin-dioxide (SnO2), aluminum zinc oxide (AlZO) and zinc oxide (ZnO), may be used to form the anode electrode. The anode layer may also be formed using metals, typically silver (Ag), gold (Au), or metal alloys.

According to one embodiment, wherein the anode layer comprises a first anode sub-layer and a second anode sub-layer, wherein
- the first anode sub-layer comprises a first metal having a work function in the range of ≥ 4 and ≤ 6 eV, and
- the second anode sub-layer comprises a transparent conductive oxide, preferably TCO.
According to one embodiment, the anode layer may comprise a first anode sub-layer comprising or consisting of Ag or Au, a second anode-sub-layer comprising or consisting of ITO or IZO and optionally a third anode sub-layer comprising or consisting of ITO or IZO.

The anode layer of the organic electronic device comprises in addition a third anode sub-layer; wherein the third anode sub-layer comprises preferably a transparent conductive oxide, wherein the third anode sub-layer is arranged between the substrate and the first anode sub-layer.

Preferably the first anode sub-layer may comprise or consists of Ag, the second anode-sublayer may comprise or consists of ITO and the third anode sub-layer may comprise or consists of ITO. Preferably, the transparent conductive oxide in the second and third anode sub-layer may be selected the same. The transparent conductive oxide may be selected from the group comprising indium tin oxide or indium zinc oxide, more preferred indium tin oxide (ITO).

According to one embodiment, the anode layer may comprise a first anode sub-layer comprising Ag or Au having a thickness of 100 to 150 nm, a second anode-sub-layer comprising ITO or IZO having a thickness of 3 to 20 nm and a third anode sub-layer comprising ITO or IZO having a thickness of 3 to 20 nm.

### Metal complex of Formula I

According to one embodiment, wherein the metal complex according to formula (I) is non-emissive.

According to one embodiment, wherein n in formula (I) is an integer from 1 to 4, preferably 1 to 3, also preferred 2 or 3. Preferably m and n in formula (I) are the same and an integer from 1 to 4, preferably 1 to 3, also preferred 2 or 3.

According to one embodiment at least one or both of the groups B¹ and B² comprises each at least 1 to 5 substituents, preferably substituents 2 to 4 or 3 substituents, independently selected from halogen, F, CF₃, C₂F₅, C₃F₇, C₄F₉, OCF₃, OC₂F₅, or CN.

### Metal complex of Formula Ia

According to one embodiment, wherein the metal complex is selected from the formula (Ia): 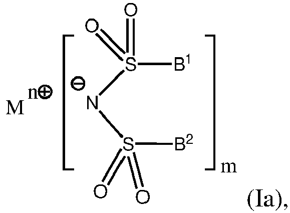 wherein
M is a metal ion;
n is the valency of M;
m is n;
B¹ and B² are independently selected from substituted C₆ to C₁₉ aryl or substituted or unsubstituted C₂ to C₂₀ heteroaryl, wherein at least one of the substituents of the substituted C₆ to C₁₉ aryl or substituted C₂ to C₂₀ heteroaryl are independently selected from halogen, Cl, F, CN, partially or perfluorinated C₁ to C₈ alkyl, partially or perfluorinated C₁ to C₈ alkoxy.

According to one embodiment at least one or both of the groups B¹ and B² comprises each at least 1 to 5 substituents, preferably substituents 2 to 4 or 3 substituents, independently selected from halogen, F, CF₃, C₂F₅, C₃F₇, C₄F₉, OCF₃, OC₂F₅, or CN.

According to one embodiment, wherein the metal complex of Formula (I) is selected from a compound W1 to W10:

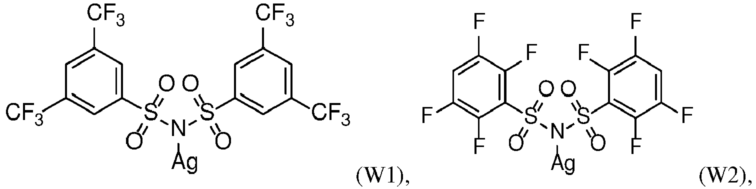

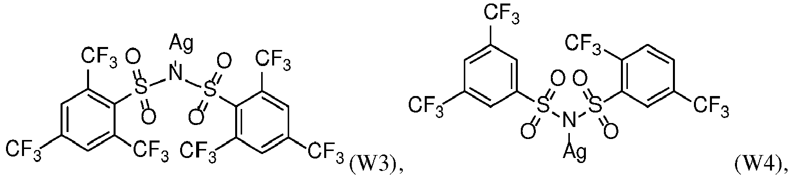

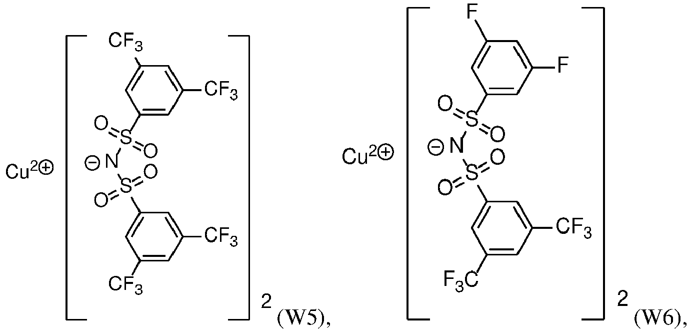

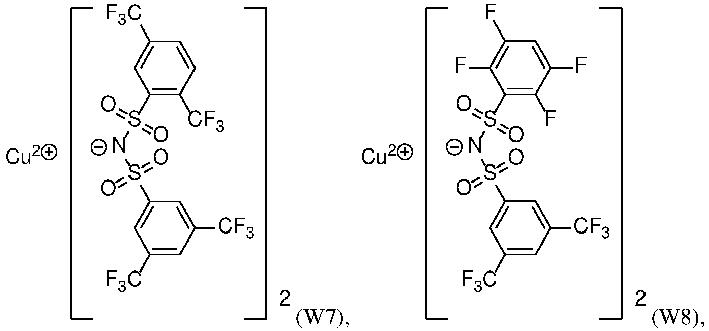

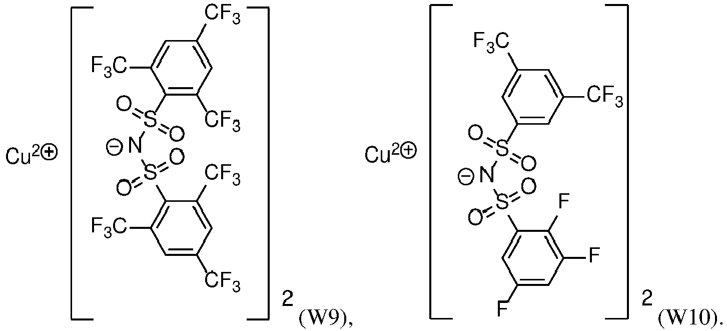

### Ligand L of formula (II)

According to one embodiment, wherein the ligand L of formula (II) may be selected from G1 to G21:

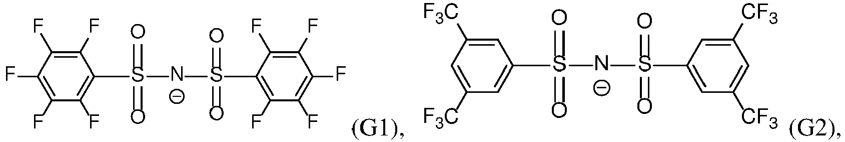

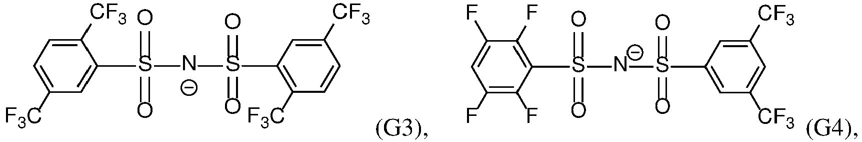

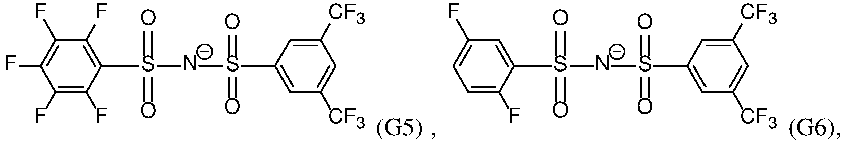

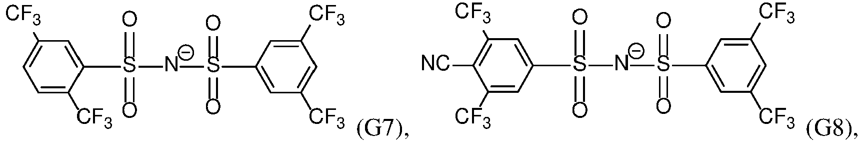

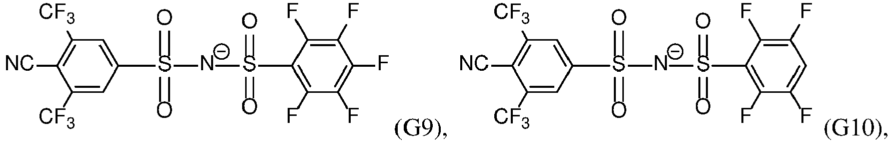

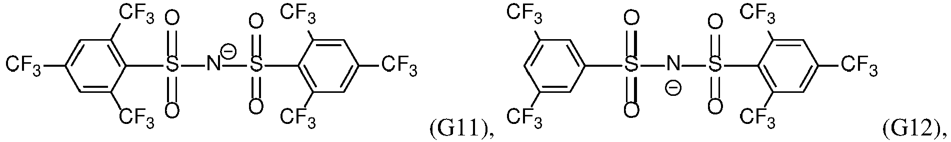

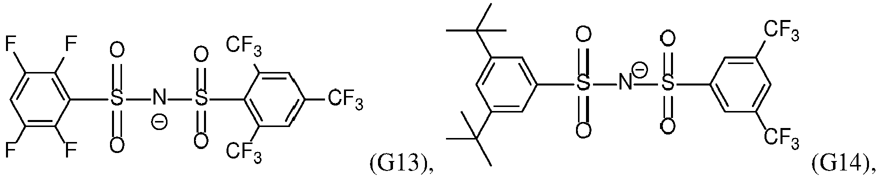

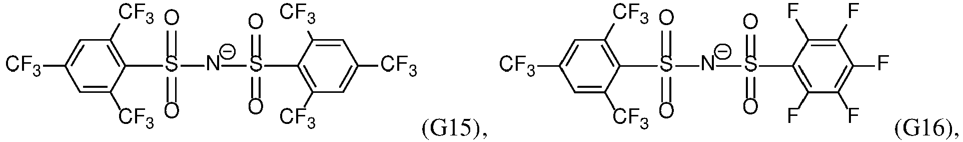

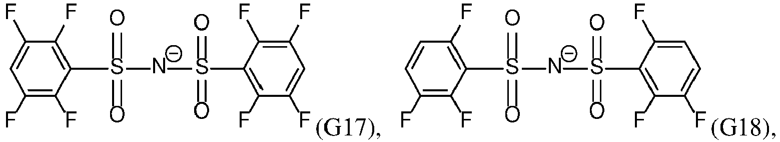

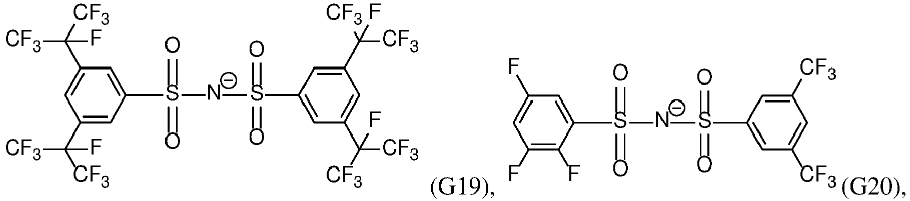

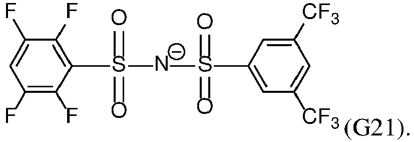

According to one embodiment, L of formula (II) is selected from the group consisting of (G1) to (G13) and (G15) to (G21), preferably from the group consisting of (G2), (G6), (G7), (G11), (G15), (G17), (G19) to (G21).

According to one embodiment, M is Ag, n is 1, m is 1, and L is selected from the group consisting of (G1) to (G13) and (G15) to (G21), preferably (G1), (G3) to (G13), (G15) to (G21).

According to one embodiment, M is Cu, n is 2, m is 2, and L is selected from the group consisting of (G1) to (G13) and (G15) to (G21), preferably (G3) to (G13), (G15) to (G21).

The negative charge in metal complexes of formulas (I) and (Ia), may be delocalised partially or fully over the A¹ and A² groups, and optionally also over the B¹ and B² groups.

### M of the metal complex of formula (I) or (Ia)

The metal complex according to formula (I) or (Ia) is non-emissive.

In the context of the present specification the term "essentially non-emissive" or "non-emissive" means that the contribution of the metal complex according to formula (I) to the visible emission spectrum from an organic electronic device, such as OLED or display device, is less than 10 %, preferably less than 5 % relative to the visible emission spectrum. The visible emission spectrum is an emission spectrum with a wavelength of about ≥ 380 nm to about ≤ 780 nm.

According to one embodiment of the present invention, the valency n of M of the metal complex according to formula (I) or (Ia) is 1, 2, 3 or 4, preferably 1, 2 or 3, or further preferred 1 or 2.

The term "electronegativity value according to Allen" especially refers to Allen, Leland C. (1989). "Electronegativity is the average one-electron energy of the valence-shell electrons in ground-state free atoms". Journal of the American Chemical Society 111 (25): 9003-9014.

According to one embodiment, wherein M of the metal complex of formula (I) or (Ia) may be selected from a metal ion wherein the corresponding metal has an electronegativity value according to Allen of less than 2.4, preferably M may be selected from an alkali, alkaline earth, rare earth, transition metal, a metal with an atomic mass ≥ 24 Da. Preferably M may be selected from a metal with an atomic mass ≥ 24 Da and M has an oxidation number ≥ 2. Further preferred, M may be selected from an alkali metal, alkaline earth metal, transition metal, or group III or V metal.

M of the metal complex of formula (I) or (Ia) may be selected from a metal ion wherein the corresponding metal may have an electronegativity value according to Allen of less than 2.4, preferably M is selected from an alkali, alkaline earth, rare earth, transition metal, or group III or V metal, further preferred M is selected from a metal with an atomic mass ≥ 24 Da, in addition preferred M is selected from a metal with an atomic mass ≥ 24 Da and M has an oxidation number ≥ 2.

The alkali metals may be selected from the group comprising Li, Na, K or Rb. The alkaline earth metals may be selected from the group comprising Mg, Ca, Sr or Ba. The transition metals may be selected from Sc, Y, La, Ti, Zr, V, Nb, Ta, Cr, Mo, W, Mn, Re, Fe, Co, Ni, Cu, Ag, Au or Zn. The group III and V metal may be selected from the group comprising Bi and Al.

According to one embodiment of the present invention, M is selected from Li, Na, K, Mg, Mn, Cu, Zn, Ag; preferably M is selected from Na, K, Mg, Mn, Cu, Zn, Ag; also preferred M is selected from Cu and/or Ag, wherein if M is Cu, n is 2.

According to one embodiment, wherein the metal complex of formula (I) may be a Cu(II) metal complex, an Ag(I) metal complex or a Zn(II) metal complex, preferably a Cu(II) metal complex or a Ag(I) metal complex.

According to one embodiment of the present invention, M is selected from an alkali, alkaline earth, rare earth or transition metal, alternatively M is selected from alkali, alkaline earth, transition or a group III metal.

According to one embodiment of the present invention, M is not Li.

The metal complex of formula (I) may have a molecular weight Mw of ≥ 339 and ≤ 2000 g/mol, preferably a molecular weight Mw of ≥ 400 and ≤ 1500 g/mol, further preferred a molecular weight Mw of ≥ 450 and ≤ 1500 g/mol, in addition preferred a molecular weight Mw of ≥ 450 and ≤ 1400 g/mol.

### Compound of formulae (III) and (IV)

Thereby, the compound of formulae (III) and (IV) may have a rate onset temperature suitable for mass production.

According to an embodiment of the organic electronic device, wherein the hole injection layer comprises a compound of formulae (III) or (IV): 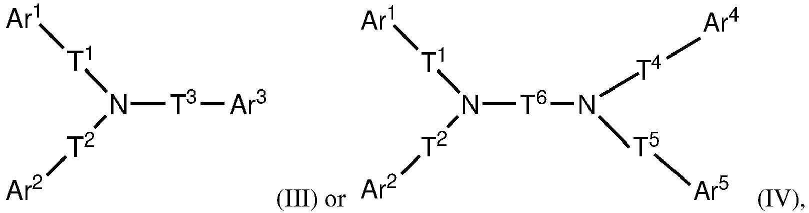 wherein
- T¹, T², T³, T⁴ and T⁵: may be independently selected from a single bond, phenylene, biphenylene, terphenylene or naphthenylene, preferably a single bond or phenylene;
- T⁶: is selected from substituted or unsubstituted phenylene, biphenylene, terphenylene or naphthenylene; wherein the substituent on phenylene is selected from C₆ to C₁₈ aryl , C₃ to C₁₈ heteroaryl, phenyl, biphenyl, carbazole, phenyl carbazole, preferably biphenyl or 9-phenyl carbazole;
- Ar¹, Ar², Ar³, Ar⁴ and Ar⁵: may be independently selected from unsubstituted C₆ to C₂₀ aryl, or unsubstituted C₃ to C₂₀ heteroarylene, unsubstituted biphenylene, unsubstituted fluorene, substituted 9-fluorene, substituted 9,9-fluorene, unsubstituted naphthalene, unsubstituted anthracene, unsubstituted phenanthrene, unsubstituted pyrene, unsubstituted perylene, unsubstituted triphenylene, unsubstituted tetracene, unsubstituted tetraphene, unsubstituted dibenzofurane, unsubstituted dibenzothiophene, unsubstituted xanthene, unsubstituted carbazole, unsubstituted 9-phenylcarbazole, unsubstituted azepine, unsubstituted dibenzo[b,f]azepine, unsubstituted 9,9'-spirobi[fluorene], substituted or unsubstituted 9,9'-spirobi[fluorene] with at least one fused aromatic ring, unsubstituted spiro[fluorene-9,9'-xanthene], a substituted or unsubstituted aromatic fused ring system comprising two aromatic 6-member rings and two aromatic 5-member rings, wherein at least one 5-member ring comprises a hetero atom, an unsubstituted aromatic fused ring system comprising two aromatic 6-member rings and two aromatic 5-member rings, wherein at least one 5-member ring comprises an O atom, or a unsubstituted aromatic fused ring system comprising at least three unsubstituted aromatic rings selected from the group comprising unsubstituted non-hetero, unsubstituted hetero 5-member rings, unsubstituted 6-member rings and/or unsubstituted 7-member rings, unsubstituted fluorene, substituted or unsubstituted fluorene with an annelated substitued or unsubstitued hetero or non-hetero ring system comprising 2 to 6 substituted or unsubstituted 5-, 6- or 7-member rings, or a fused ring system comprising 2 to 6 unsubstituted 5- to 7-member rings and the rings are selected from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle.

According to an embodiment of the organic electronic device, wherein the hole injection layer comprises a compound of formulae (III) or (IV): 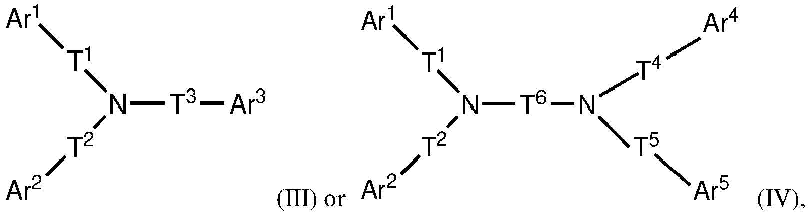 wherein
- T¹, T², T³, T⁴ and T⁵: may be independently selected from a single bond, phenylene, biphenylene, terphenylene or naphthenylene, preferably a single bond or phenylene;
- T⁶: is selected from substituted or unsubstituted phenylene, biphenylene, terphenylene or naphthenylene; wherein the substituent on phenylene is selected from C₆ to C₁₈ aryl , C₃ to C₁₈ heteroaryl, phenyl, biphenyl, carbazole, phenyl carbazole, preferably biphenyl or 9-phenyl carbazole;
- Ar¹, Ar², Ar³, Ar⁴ and Ar⁵: may be independently selected from unsubstituted C₆ to C₂₀ aryl, or unsubstituted C₃ to C₂₀ heteroarylene, unsubstituted biphenylene, unsubstituted fluorene, substituted 9-fluorene, substituted 9,9-fluorene, unsubstituted naphthalene, unsubstituted anthracene, unsubstituted phenanthrene, unsubstituted pyrene, unsubstituted perylene, unsubstituted triphenylene, unsubstituted tetracene, unsubstituted tetraphene, unsubstituted dibenzofurane, unsubstituted dibenzothiophene, unsubstituted xanthene, unsubstituted carbazole, substituted 9-phenylcarbazole, unsubstituted azepine, unsubstituted dibenzo[b,f]azepine, unsubstituted 9,9'-spirobi[fluorene], substituted or unsubstituted 9,9'-spirobi[fluorene] with at least one fused aromatic ring, unsubstituted spiro[fluorene-9,9'-xanthene], a substituted or unsubstituted aromatic fused ring system comprising two aromatic 6-member rings and two aromatic 5-member rings, wherein at least one 5-member ring comprises a hetero atom, a substituted or unsubstituted aromatic fused ring system comprising two aromatic 6-member rings and two aromatic 5-member rings, wherein at least one 5-member ring comprises an O atom, substituted or unsubstituted fluorene with an annelated substitued or unsubstitued hetero or non-hetero ring system comprising 2 to 6 substituted or unsubstituted 5-, 6- or 7-member rings.

Thereby, the compound of formulae (III) or (IV) may have a rate onset temperature suitable for mass production.

The substituents of Ar¹, Ar², Ar³, Ar⁴ and Ar⁵ if not otherwise mentioned are selected the same or different from the group comprising H, D, F, C(=O)R², CN, Si(R²)₃, P(=O)(R²)₂, OR², S(=O)R², S(=O)₂R², substituted or unsubstituted straight-chain alkyl having 1 to 20 carbon atoms, substituted or unsubstituted branched alkyl having 1 to 20 carbon atoms, substituted or unsubstituted cyclic alkyl having 3 to 20 carbon atoms, substituted or unsubstituted alkenyl or alkynyl groups having 2 to 20 carbon atoms, substituted or unsubstituted alkoxy groups having 1 to 20 carbon atoms, substituted or unsubstituted aromatic ring systems having 6 to 40 aromatic ring atoms, and substituted or unsubstituted heteroaromatic ring systems having 5 to 40 aromatic ring atoms, unsubstituted C₆ to C₁₈ aryl, unsubstituted C₃ to C₁₈ heteroaryl, a fused ring system comprising 2 to 6 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle,
wherein R² is selected from H, D, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, C₆ to C₁₈ aryl or C₃ to C₁₈ heteroaryl.

According to an embodiment wherein T¹, T², T³, T⁴ and T⁵, or T¹, T² and T³ may be independently selected from a single bond, phenylene, biphenylene or terphenylene. According to an embodiment wherein T¹, T², T³, T⁴ and T⁵, or T¹, T² and T³ may be independently selected from phenylene, biphenylene or terphenylene and one of T¹, T², T³, T⁴ and T⁵, or T¹, T² and T³ are a single bond. According to an embodiment wherein T¹, T², T³, T⁴ and T⁵, or T¹, T² and T³ may be independently selected from phenylene or biphenylene and one of T¹, T², T³, T⁴ and T⁵, or T¹, T² and T³ are a single bond. According to an embodiment wherein T¹, T², T³, T⁴ and T⁵, or T¹, T² and T³ may be independently selected from phenylene or biphenylene and two of T¹, T², T³, T⁴ and T⁵, or T¹, T² and T³ are a single bond.

According to an embodiment wherein T¹, T², T³, T⁴ and T⁵, or T¹, T² and T³ may be independently selected from phenylene and one of T¹, T², T³, T⁴ and T⁵, or T¹, T² and T³ are a single bond. According to an embodiment wherein T¹, T², T³, T⁴ and T⁵, or T¹, T² and T³ may be independently selected from phenylene and two of T¹, T², T³, T⁴ and T⁵, or T¹, T² and T³ are a single bond.

According to another embodiment, wherein Ar¹, Ar², Ar³, Ar⁴ and Ar⁵, or Ar¹, Ar² and Ar³ are independently selected from D1 to D22: 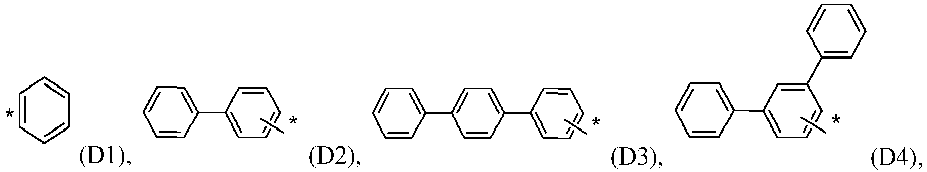 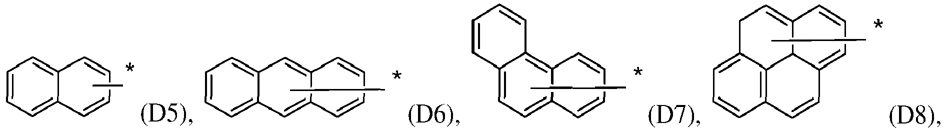 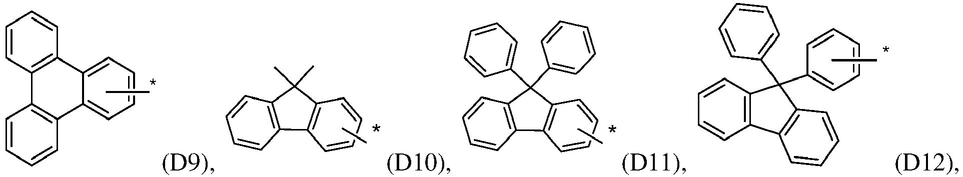 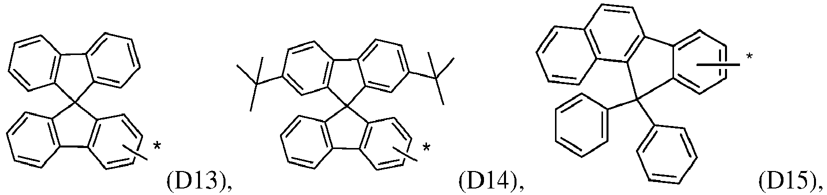 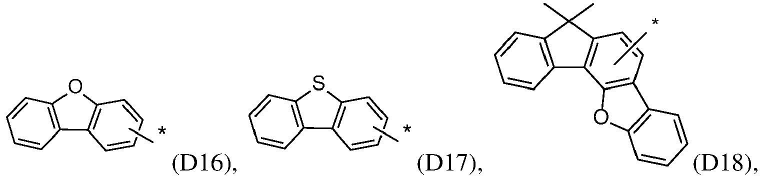 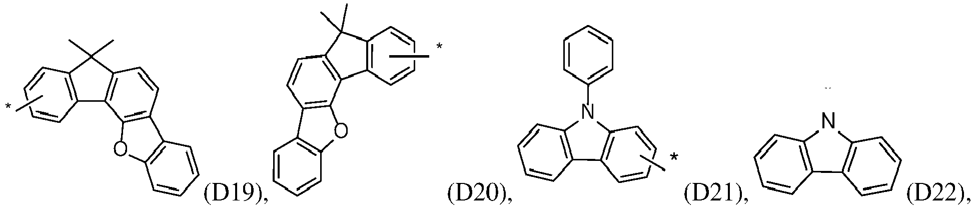 wherein the asterix "*" denotes the binding position.

According to an embodiment, wherein Ar¹, Ar², Ar³, Ar⁴ and Ar⁵, or Ar¹, Ar² and Ar³ may be independently selected from D1 to D21; alternatively selected from D1 to D13 and D15 to D21.

According to an embodiment, wherein Ar¹, Ar², Ar³, Ar⁴ and Ar⁵, or Ar¹, Ar² and Ar³ may be independently selected from the group consisting of D1, D2, D5, D7, D9, D10 to D21.

The rate onset temperature may be in a range particularly suited to mass production, when Ar¹, Ar², Ar³, Ar⁴ and Ar⁵, or Ar¹, Ar² and Ar³ are selected in this range.

According to an embodiment, wherein T⁶ is substituted phenylene and the subsituent on phenylene is selected from D1 to D21; preferably from D1, D2, D5, D10 to D13, D16, D17, D20.

The "compound of formulae (III) or (IV) " may be also referred to as "hole transport compound".

According to one embodiment the compound of formulae (III) or (IV) may comprise at least ≥ 1 to ≤ 6 substituted or unsubstituted aromatic fused ring systems comprising heteroaromatic rings.

According to one embodiment the compound of formulae (III) or (IV) may comprise at least ≥ 1 to ≤ 6 substituted or unsubstituted aromatic fused ring systems comprising heteroaromatic rings and at least ≥ 1 to ≤ 3 substituted or unsubstituted unsaturated 5- to 7-member ring of a heterocycle, preferably ≥ 2 to ≤ 5 substituted or unsubstituted aromatic fused ring systems comprising heteroaromatic rings.

According to one embodiment the compound of formula formulae (III) or (IV) may comprise at least ≥ 1 to ≤ 6 substituted or unsubstituted aromatic fused ring systems comprising heteroaromatic rings and at least ≥ 1 to ≤ 3 substituted or unsubstituted unsaturated 5- to 7-member ring of a heterocycle, preferably ≥ 2 to ≤ 5 substituted or unsubstituted aromatic fused ring systems comprising heteroaromatic rings, and at least ≥ 1 to ≤ 3 substituted or unsubstituted unsaturated 5- to 7-member ring of a heterocycle, further preferred 3 or 4 substituted or unsubstituted aromatic fused ring systems comprising heteroaromatic rings and optional at least ≥ 1 to ≤ 3 substituted or unsubstituted unsaturated 5- to 7-member ring of a heterocycle, and additional preferred wherein the aromatic fused ring systems comprising heteroaromatic rings are unsubstituted and optional at least ≥ 1 to ≤ 3 unsubstituted unsaturated 5- to 7-member ring of a heterocycle.

According to one embodiment the compound of formulae (III) or (IV) may comprise at least ≥ 1 to ≤ 6 substituted or unsubstituted aromatic fused ring systems, preferably ≥ 2 to ≤ 5 substituted or unsubstituted aromatic fused ring systems, and further preferred 3 or 4 substituted or unsubstituted aromatic fused ring systems.

According to one embodiment the compound of formulae (III) or (IV) may comprise at least ≥ 1 to ≤ 6 substituted or unsubstituted aromatic fused ring systems, preferably ≥ 2 to ≤ 5 substituted or unsubstituted aromatic fused ring systems, and further preferred 3 or 4 substituted or unsubstituted aromatic fused ring systems, which comprises substituted or unsubstituted heteroaromatic rings.

According to one embodiment the compound of formulae (III) or (IV) may comprise at least ≥ 1 to ≤ 3 or 2 substituted or unsubstituted unsaturated 5- to 7-member ring of a heterocycle.

According to one embodiment the compound of formulae (III) or (IV) may comprise at least ≥ 1 to ≤ 3 or 2 substituted or unsubstituted unsaturated 7-member ring of a heterocycle.

According to one embodiment substituted or unsubstituted aromatic fused ring systems of the matrix compound of formulae (III) or (IV) may comprise at least ≥ 1 to ≤ 3 or 2 substituted or unsubstituted unsaturated 5- to 7-member ring of a heterocycle.

According to one embodiment the substituted or unsubstituted aromatic fused ring systems of the compound of formulae (III) or (IV) may comprise at least ≥ 1 to ≤ 3 or 2 substituted or unsubstituted unsaturated 7-member ring of a heterocycle.

According to one embodiment the compound of formulae (III) or (IV) may comprise at least ≥ 1 to ≤ 6 substituted or unsubstituted aromatic fused ring systems, preferably ≥ 2 to ≤ 5 substituted or unsubstituted aromatic fused ring systems, and further preferred 3 or 4 substituted or unsubstituted aromatic fused ring systems, and wherein the aromatic fused ring system comprises substituted or unsubstituted unsaturated 5- to 7-member ring of a heterocycle.

According to one embodiment the compound of formulae (III) or (IV) may comprise at least ≥ 1 to ≤ 6 substituted or unsubstituted aromatic fused ring systems, preferably ≥ 2 to ≤ 5 substituted or unsubstituted aromatic fused ring systems, and further preferred 3 or 4 substituted or unsubstituted aromatic fused ring systems, which comprises substituted or unsubstituted heteroaromatic rings, and wherein the aromatic fused ring system comprises substituted or unsubstituted unsaturated 5- to 7-member ring of a heterocycle.

According to one embodiment the compound of formulae (III) or (IV) may comprise at least ≥ 1 to ≤ 6 substituted or unsubstituted aromatic fused ring systems, preferably ≥ 2 to ≤ 5 substituted or unsubstituted aromatic fused ring systems, and further preferred 3 or 4 substituted or unsubstituted aromatic fused ring systems, and wherein the aromatic fused ring system comprises at least ≥ 1 to ≤ 3 or 2 substituted or unsubstituted unsaturated 5- to 7-member ring of a heterocycle.

According to one embodiment the compound of formulae (III) or (IV) may comprise at least ≥ 1 to ≤ 6 substituted or unsubstituted aromatic fused ring systems, preferably ≥ 2 to ≤ 5 substituted or unsubstituted aromatic fused ring systems, and further preferred 3 or 4 substituted or unsubstituted aromatic fused ring systems, which comprises substituted or unsubstituted heteroaromatic rings, and wherein the aromatic fused ring system comprises at least ≥ 1 to ≤ 3 or 2 substituted or unsubstituted unsaturated 5- to 7-member ring of a heterocycle.

According to one embodiment the compound of formulae (III) or (IV) may comprises:
- a substituted or unsubstituted aromatic fused ring system with at least ≥ 2 to ≤ 6, preferably ≥ 3 to ≤ 5, or 4 fused aromatic rings selected from the group comprising substituted or unsubstituted non-hetero aromatic rings, substituted or unsubstituted hetero 5-member rings, substituted or unsubstituted 6-member rings and/or substituted or unsubstituted unsaturated 5-to 7- member ring of a heterocycle; or
- an unsubstituted aromatic fused ring systems with at least ≥ 2 to ≤ 6, preferably ≥ 3 to ≤ 5, or 4 fused aromatic rings selected from the group comprising unsubstituted non-hetero aromatic rings, unsubstituted hetero 5-member rings, unsubstituted 6-member rings and/or unsubstituted unsaturated 5- to 7-member ring of a heterocycle.

It should be noted here that the wording "aromatic fused ring system" may include at least one aromatic ring and at least one substituted or unsubstituted unsaturated 5- to 7- member ring. It should be noted here that the substituted or unsubstituted unsaturated 5- to 7- member ring may not be an aromatic ring.

According to one embodiment the compound of formulae (III) or (IV) may comprise at least at least ≥ 1 to ≤ 6, preferably ≥ 2 to ≤ 5, or further preferred 3 or 4 of the substituted or unsubstituted aromatic fused ring systems with:
- at least one unsaturated 5-member ring, and/or
- at least one unsaturated 6-member ring, and/or
- at least one unsaturated 7-member ring; wherein preferably at least one unsaturated 5- and/or at least one unsaturated 7-member ring comprises at least 1 to 3, preferably 1 hetero-atom.

According to one embodiment the compound of formulae (III) or (IV) may comprise at least at least ≥ 1 to ≤ 6, preferably ≥ 2 to ≤ 5, or further preferred 3 or 4 of the substituted or unsubstituted aromatic fused ring systems with:
- at least one aromatic 5-member ring, and/or
- at least one aromatic 6-member ring, and/or
- at least one aromatic 7-member ring; wherein preferably at least one aromatic 5- and/or at least one aromatic 7-member ring comprises at least 1 to 3, preferably 1 hetero-atom;
wherein the substituted or unsubstituted aromatic fused ring system comprises at least ≥ 1 to ≤ 3 or 2 substituted or unsubstituted unsaturated 5- to 7-member ring of a heterocycle.

According to one embodiment the compound of formulae (III) or (IV) may comprise:
- at least ≥ 6 to ≤ 12, preferably ≥ 7 to ≤ 11, further preferred ≥ 8 to ≤ 10 or 9 aromatic rings; and/or
- at least ≥ 4 to ≤ 11, preferably ≥ 5 to ≤ 10, further preferred ≥ 6 to ≤ 9 or in addition preferred 7 or 8 non-hetero aromatic rings, preferably the non-hetero aromatic rings are aromatic C₆ rings; and/or
- at least ≥ 1 to ≤ 4, preferably 2 or 3 aromatic 5-member-rings, preferably hetero aromatic 5-member-rings; and/or
- at least 1 or 2 unsaturated 5- to 7-member-ring of a heterocycle, preferably at least 1 or 2 unsaturated 7-member-ring of a heterocycle;
- at least ≥ 6 to ≤ 12, preferably ≥ 7 to ≤ 11, further preferred ≥ 8 to ≤ 10 or 9 aromatic rings, wherein therefrom
   at least ≥ 4 to ≤ 11, preferably ≥ 5 to ≤ 10, further preferred ≥ 6 to ≤ 9 or in addition preferred 7 or 8 are non-hetero aromatic rings, and
   at least ≥ 1 to ≤ 4, preferably 2 or 3 aromatic rings are hetero aromatic rings, wherein the total number of non-hetero aromatic rings and hetero aromatic rings in total does not exceed 12 aromatic rings; and/or
- at least ≥ 6 to ≤ 12, preferably ≥ 7 to ≤ 11, further preferred ≥ 8 to ≤ 10 or 9 aromatic rings, wherein therefrom
   at least ≥ 4 to ≤ 11, preferably ≥ 5 to ≤ 10, further preferred ≥ 6 to ≤ 9 or in addition preferred 7 or 8 are non-hetero aromatic rings, and
   at least ≥ 1 to ≤ 4, preferably 2 or 3 aromatic rings are hetero aromatic rings, wherein the total number of non-hetero aromatic rings and hetero aromatic rings in total does not exceed 12 aromatic rings.

According to one embodiment the compound of formulae (III) or (IV) may comprise at least at least ≥ 1 to ≤ 6, preferably ≥ 2 to ≤ 5, or further preferred 3 or 4 of the substituted or unsubstituted aromatic fused ring systems with:
- at least one aromatic 5-member ring, and/or
- at least one aromatic 6-member ring, and/or
- at least one aromatic 7-member ring; wherein preferably at least one aromatic 5- and/or at least one aromatic 7-member ring comprises at least 1 to 3, preferably 1 hetero-atom;
wherein the substituted or unsubstituted aromatic fused ring system optional comprises at least ≥ 1 to ≤ 3 or 2 substituted or unsubstituted unsaturated 5- to 7-member ring of a heterocycle; and wherein the substituted or unsubstituted aromatic fused ring system comprises a hetero-atom, which may be selected from the group comprising O, S, N, B, P or Si, preferably the hetero-atom may be selected from the group comprising O, S or N.

According to another embodiment, wherein the compound of formulae (III) or (IV) is selected from F1 to F19:

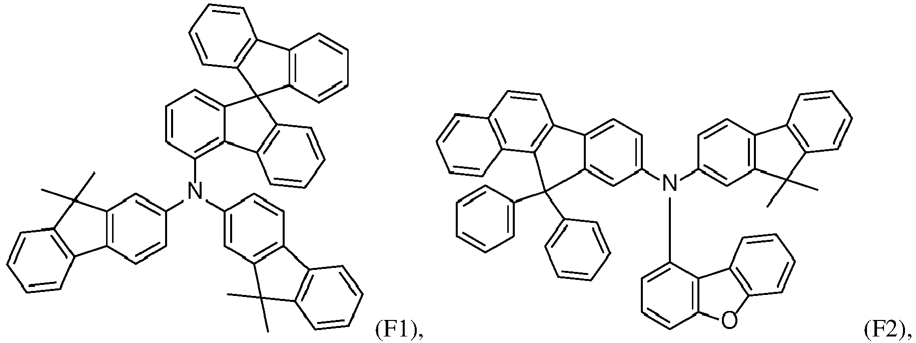

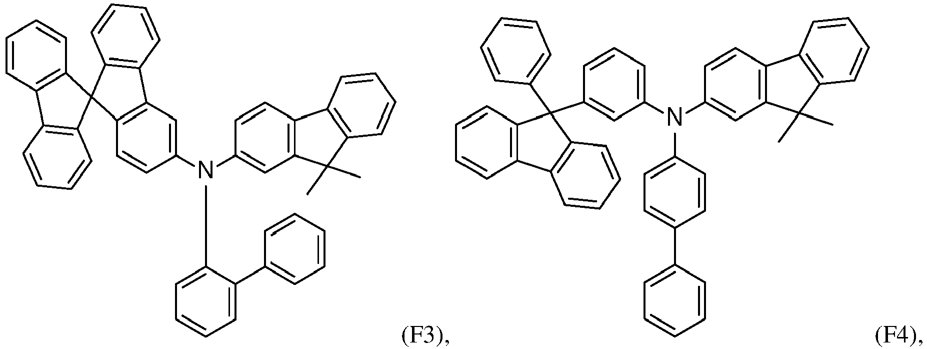

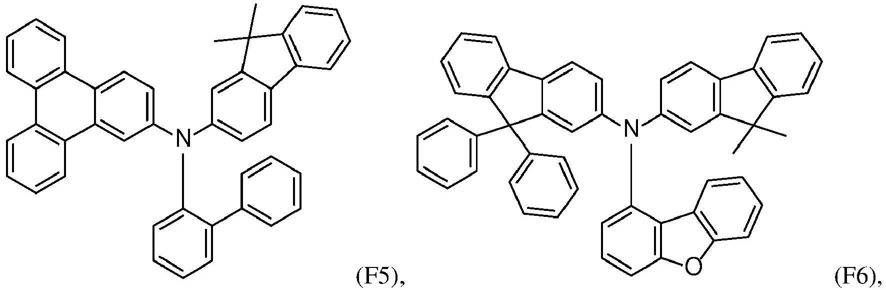

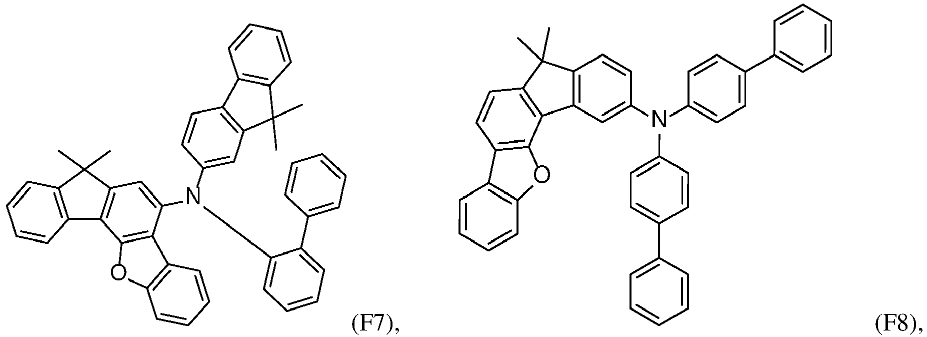

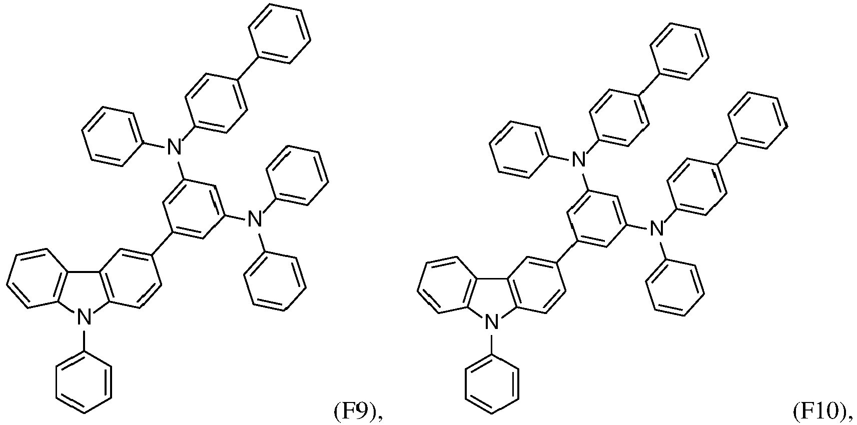

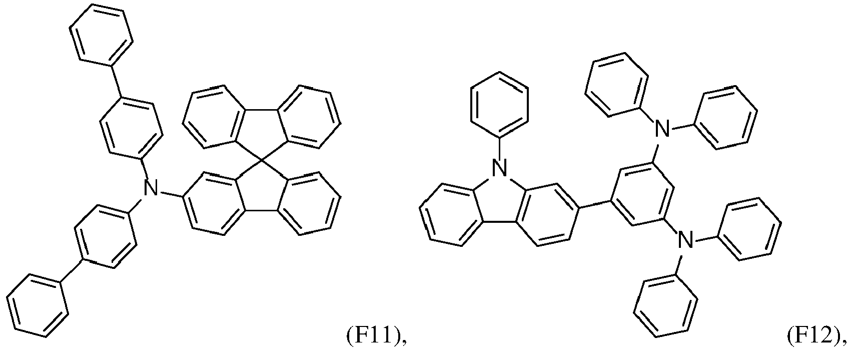

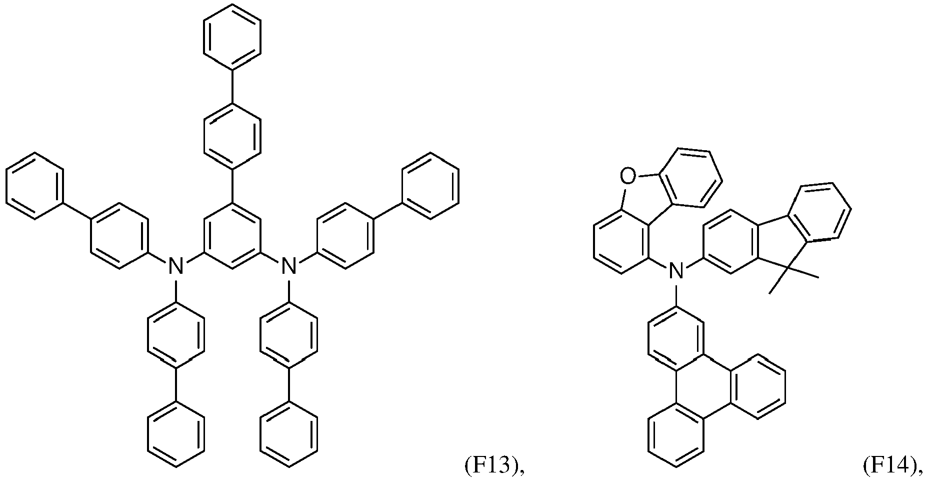

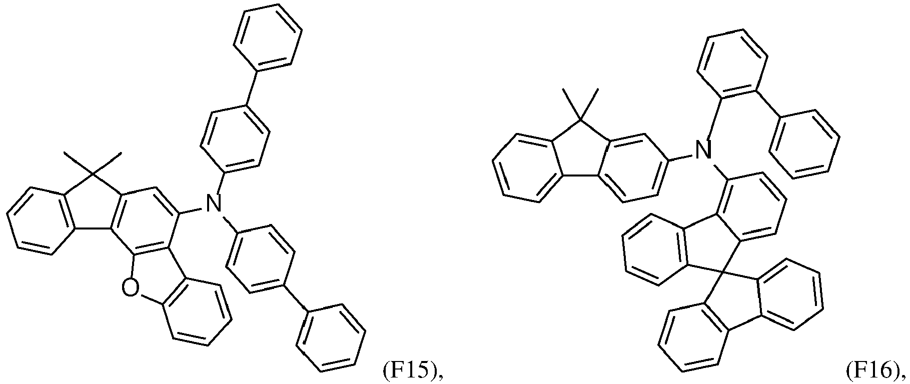

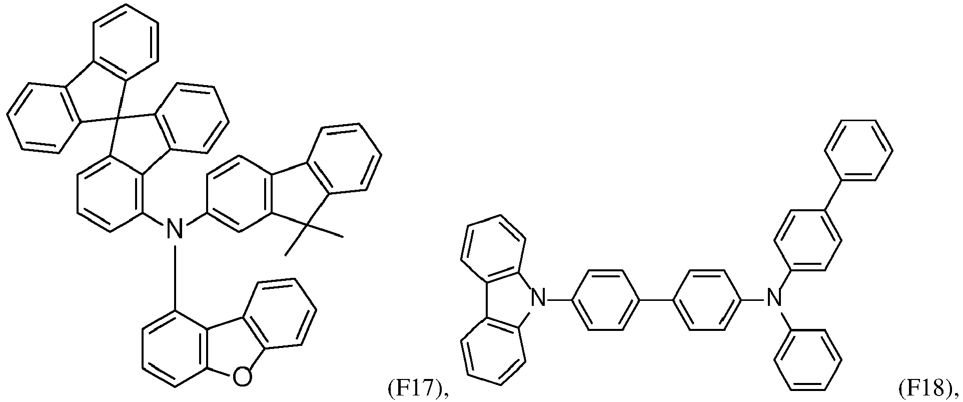

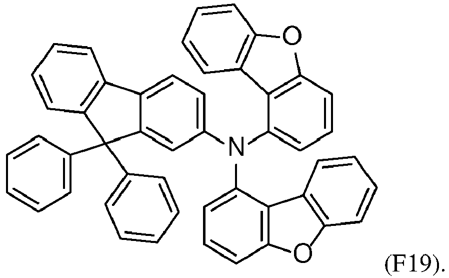

The hole injection layer may be free of HTM014, HTM081, HTM163, HTM222, EL-301, HTM226, HTM355, HTM133, HTM334, HTM604 and EL-22T. The abbreviations denote the manufacturers' names, for example, of Merck or Lumtec.

According to one embodiment, the compounds of formulae (III) or (IV) may have a molecular weight Mw of ≥ 400 and ≤ 2000 g/mol, preferably a molecular weight Mw of ≥ 450 and ≤ 1500 g/mol, further preferred a molecular weight Mw of ≥ 500 and ≤ 1000 g/mol, in addition preferred a molecular weight Mw of ≥ 550 and ≤ 900 g/mol.

In one embodiment, the HOMO level of the substantially covalent matrix compound may be more negative than the HOMO level of N-([1,1'-biphenyl]-4-yl)-9,9-dimethyl-N-(4-(9-phenyl-9H-carbazol-3-yl)phenyl)-9H-fluoren-2-amine (CAS 1242056-42-3) when determined under the same conditions.

In one embodiment, the HOMO level of the substantially covalent matrix compound , when calculated using TURBOMOLE V6.5 (TURBOMOLE GmbH, Litzenhardtstrasse 19, 76135 Karlsruhe, Germany) by applying the hybrid functional B3LYP with a 6-31G* basis set in the gas phase, may be ≤ -4.8 eV, also preferred ≤ -4.805 eV, also preferred ≤ -4.815 eV; and > 6.5 eV.

In one embodiment, the HOMO level of the substantially covalent matrix compound, when calculated using TURBOMOLE V6.5 (TURBOMOLE GmbH, Litzenhardtstrasse 19, 76135 Karlsruhe, Germany) by applying the hybrid functional B3LYP with a 6-31G* basis set in the gas phase, may be selected in the range of < -4.79 eV and ≥ -5.5 eV, alternatively in the range of ≤ -4.8 eV and ≥ -5.3 eV, alternatively in the range of ≤ -4.8 eV and ≥ -5.2 eV, alternatively in the range of ≤ -4.8 eV and ≥ -5 eV, alternatively in the range of < -4.8 eV and ≥ -5 eV.

In one embodiment of the present invention, the substantially covalent matrix compound may be free of alkoxy groups.

### Hole injection layer

The hole injection layer (HIL) may be formed on the anode layer by vacuum deposition, spin coating, printing, casting, slot-die coating, Langmuir-Blodgett (LB) deposition, or the like. When the HIL is formed using vacuum deposition, the deposition conditions may vary according to the hole transport compound that is used to form the HIL, and the desired structure and thermal properties of the HIL. In general, however, conditions for vacuum deposition may include a deposition temperature of 100° C to 350° C, a pressure of 10⁻⁸ to 10⁻³ Torr (1 Torr equals 133.322 Pa), and a deposition rate of 0.1 to 10 nm/sec.

When the HIL is formed using spin coating or printing, coating conditions may vary according to the hole transport compound that is used to form the HIL, and the desired structure and thermal properties of the HIL. For example, the coating conditions may include a coating speed of about 2000 rpm to about 5000 rpm, and a thermal treatment temperature of about 80° C to about 200° C. Thermal treatment removes a solvent after the coating is performed.

The thickness of the HIL may be in the range from about 1 nm to about 15 nm, and for example, from about 2 nm to about 15 nm, alternatively about 2 nm to about 12 nm.

When the thickness of the HIL is within this range, the HIL may have excellent hole injecting characteristics, without a substantial penalty in driving voltage.

According to one embodiment of the present invention, the hole injection layer may comprise:
- at least about ≥ 0.5 wt.-% to about ≤ 30 wt.-%, preferably about ≥ 0.5 wt.-% to about ≤ 20 wt.-%, and more preferred about ≥ 2 wt.-% to about ≤ 15 wt.-% of a metal complex of formula (I) or formula (Ia), and
- at least about ≥ 70 wt.-% to about ≤ 99.5 wt.-%, preferably about ≥ 80 wt.-% to about ≤ 99.5 wt.-%, and more preferred about ≥ 85 wt.-% to about ≤ 98 wt.-% of a compound of formulae (III) or (IV); preferably the wt.-% of the metal complex of formula (I) or formula (Ia) is lower than the wt.-% of a compound according to formulae (III) or (IV); wherein the weight-% of the components are based on the total weight of the hole injection layer.

According to one embodiment of the present invention, the hole injection layer may comprise:
- at least about ≥ 0.5 vol.-% to about ≤ 30 vol.-%, preferably about ≥ 0.5 vol.-% to about ≤ 20 vol.-%, and more preferred about ≥ 2 vol.-% to about ≤ 15 vol.-% of a metal complex of formula (I) or formula (Ia), and
- at least about ≥ 70 vol.-% to about ≤ 99.5 vol.-%, preferably about ≥ 80 vol.-% to about ≤ 99.5 vol.-%, and more preferred about ≥ 85 vol.-% to about ≤ 98 vol.-% of a compound of formulae (III) or (IV) ; preferably the vol.-% of the metal complex of formula (I) or formula (Ia) is lower than the vol.-% of a compound according to formulae (III) or (IV) ; wherein the vol.-% of the components are based on the total volume of the hole injection layer.

According to an embodiment of the organic electronic device, wherein the hole injection layer is non-emissive.

It is to be understood that the hole injection layer is not part of the anode layer.

### Further layers

In accordance with the invention, the organic electronic device may comprise, besides the layers already mentioned above, further layers. Exemplary embodiments of respective layers are described in the following:

### Substrate

The substrate may be any substrate that is commonly used in manufacturing of, electronic devices, such as organic light-emitting diodes. If light is to be emitted through the substrate, the substrate shall be a transparent or semitransparent material, for example a glass substrate or a transparent plastic substrate. If light is to be emitted through the top surface, the substrate may be both a transparent as well as a non-transparent material, for example a glass substrate, a plastic substrate, a metal substrate, a silicon substrate or a transistor backplane. Preferably, the substrate is a silicon substrate or backplane for a display.

### Hole transport layer

According to one embodiment of the organic electronic device, wherein the organic electronic device further comprises a hole transport layer, wherein the hole transport layer is arranged between the hole injection layer and the at least one emission layer or first emission layer.

The hole transport layer may comprise a substantially covalent matrix compound. According to one embodiment the substantially covalent matrix compound of the hole transport layer may be selected from at least one organic compound. The substantially covalent matrix may consist substantially from covalently bound C, H, O, N, S, which optionally comprise in addition covalently bound B, P, As and/or Se.

According to one embodiment of the organic electronic device, the hole transport layer comprises a matrix compound, wherein the matrix compound of the hole transport layer may be selected from organic compounds consisting or substantially consist from covalently bound C, H, O, N, S, which optionally comprise in addition covalently bound B, P, As and/or Se.

According to one embodiment, the substantially covalent matrix compound of the hole transport layer may have a molecular weight Mw of ≥ 400 and ≤ 2000 g/mol, preferably a molecular weight Mw of ≥ 450 and ≤ 1500 g/mol, further preferred a molecular weight Mw of ≥ 500 and ≤ 1000 g/mol, in addition preferred a molecular weight Mw of ≥ 550 and ≤ 900 g/mol.

According to one embodiment of the organic electronic device, wherein the hole transport layer may comprise a matrix compound according to formulae (III) or (IV), preferably the matrix compound in the hole injection layer and hole transport layer are selected the same.

According to one embodiment of the organic electronic device, wherein the hole transport layer comprises a compound according to formulae (III) or (IV), preferably the matrix compound in the hole injection layer and hole transport layer are selected the same.

The hole transport layer may be free of HTM014, HTM081, HTM163, HTM222, EL-301, HTM226, HTM355, HTM133, HTM334, HTM604 and EL-22T. The abbreviations denote the manufacturers' names, for example, of Merck or Lumtec.

The hole transport layer (HTL) may be formed on the HIL by vacuum deposition, spin coating, slot-die coating, printing, casting, Langmuir-Blodgett (LB) deposition, or the like. When the HTL is formed by vacuum deposition or spin coating, the conditions for deposition and coating may be similar to those for the formation of the HIL. However, the conditions for the vacuum or solution deposition may vary, according to the hole transport compound that is used to form the HTL.

The thickness of the HTL may be in the range of about 5 nm to about 250 nm, preferably, about 10 nm to about 200 nm, further about 20 nm to about 190 nm, further about 40 nm to about 180 nm, further about 60 nm to about 170 nm, further about 80 nm to about 200 nm, further about 100 nm to about 180 nm, further about 110 nm to about 140 nm.

When the thickness of the HTL is within this range, the HTL may have excellent hole transporting characteristics, without a substantial penalty in driving voltage.

### Electron blocking layer

The function of an electron blocking layer (EBL) is to prevent electrons from being transferred from an emission layer to the hole transport layer and thereby confine electrons to the emission layer. Thereby, efficiency, operating voltage and/or lifetime may be improved. Typically, the electron blocking layer comprises a triarylamine compound.

If the electron blocking layer has a high triplet level, it may also be described as triplet control layer.

The function of the triplet control layer is to reduce quenching of triplets if a phosphorescent green or blue emission layer is used. Thereby, higher efficiency of light emission from a phosphorescent emission layer can be achieved. The triplet control layer may be selected from triarylamine compounds with a triplet level above the triplet level of the phosphorescent emitter in the adjacent emission layer.

The thickness of the electron blocking layer may be selected between 2 and 20 nm.

### Emission layer (EML)

The at least one first emission layer (EML), also referred to as first emission layer may be formed on the HTL or EBL by vacuum deposition, spin coating, slot-die coating, printing, casting, LB deposition, or the like. When the EML is formed using vacuum deposition or spin coating, the conditions for deposition and coating may be similar to those for the formation of the HIL. However, the conditions for deposition and coating may vary, according to the compound that is used to form the EML.

According to the present invention it is preferred that the organic electronic device comprises one emission layer that is named "first emission layer". However, the organic electronic device optionally comprises two emission layers, wherein the first layer is named first emission layer and second layer is named second emission layer.

It may be provided that the at least one emission layer also referred to as first emission layer is free of the hole injection layer.

It may be provided that the at least one emission layer does not comprise the compound of formulae (III) or (IV).

The at least one emission layer (EML) may be formed of a combination of a host and an emitter dopant. Example of the host are Alq3, 4,4'-N,N'-dicarbazole-biphenyl (HTC-10), poly(n-vinyl carbazole) (PVK), 9,10-di(naphthalene-2-yl)anthracene (ADN), 4,4',4"-tris(carbazol-9-yl)-triphenylamine(TCTA), 1,3,5-tris(N-phenylbenzimidazole-2-yl)benzene (TPBI), 3-tert-butyl-9,10-di-2-naphthylanthracenee (TBADN), distyrylarylene (DSA) and bis(2-(2-hydroxyphenyl)benzo-thiazolate)zinc (Zn(B TZ)2).

The emitter dopant may be a phosphorescent or fluorescent emitter. Phosphorescent emitters and emitters which emit light via a thermally activated delayed fluorescence (TADF) mechanism may be preferred due to their higher efficiency. The emitter may be a small molecule or a polymer.

Examples of red emitter dopants are PtOEP, Ir(piq)3, and Btp2lr(acac), but are not limited thereto. These compounds are phosphorescent emitters; however, fluorescent red emitter dopants could also be used.

Examples of phosphorescent green emitter dopants are Ir(ppy)3 (ppy = phenylpyridine), Ir(ppy)2(acac), Ir(mpyp)3.

Examples of phosphorescent blue emitter dopants are F2Irpic, (F2ppy)₂Ir(tmd) and Ir(dfppz)3 and ter-fluorene. 4.4'-bis(4-diphenyl amiostyryl)biphenyl (DPAVBi), 2,5,8,11-tetra-tert-butyl perylene (TBPe) are examples of fluorescent blue emitter dopants.

The amount of the emitter dopant may be in the range from about 0.01 to about 50 parts by weight, based on 100 parts by weight of the host. Alternatively, the at least one emission layer may consist of a light-emitting polymer. The EML may have a thickness of about 10 nm to about 100 nm, for example, from about 20 nm to about 60 nm. When the thickness of the EML is within this range, the EML may have excellent light emission, without a substantial penalty in driving voltage.

### Hole blocking layer (HBL)

A hole blocking layer (HBL) may be formed on the EML, by using vacuum deposition, spin coating, slot-die coating, printing, casting, LB deposition, or the like, in order to prevent the diffusion of holes into the ETL. When the EML comprises a phosphorescent emitter dopant, the HBL may have also a triplet exciton blocking function.

The HBL may also be named auxiliary ETL or a-ETL.

When the HBL is formed using vacuum deposition or spin coating, the conditions for deposition and coating may be similar to those for the formation of the HIL. However, the conditions for deposition and coating may vary, according to the compound that is used to form the HBL. Any compound that is commonly used to form a HBL may be used. Examples of compounds for forming the HBL include oxadiazole derivatives, triazole derivatives, phenanthroline derivatives and triazine derivatives.

The HBL may have a thickness in the range from about 5 nm to about 100 nm, for example, from about 10 nm to about 30 nm. When the thickness of the HBL is within this range, the HBL may have excellent hole-blocking properties, without a substantial penalty in driving voltage.

### Electron transport layer (ETL)

The organic electronic device according to the present invention may further comprise an electron transport layer (ETL).

According to another embodiment of the present invention, the electron transport layer may further comprise an azine compound, preferably a triazine compound.

In one embodiment, the electron transport layer may further comprise a dopant selected from an alkali organic complex, preferably LiQ

The thickness of the ETL may be in the range from about 15 nm to about 50 nm, for example, in the range from about 20 nm to about 40 nm. When the thickness of the EIL is within this range, the ETL may have satisfactory electron-injecting properties, without a substantial penalty in driving voltage.

According to another embodiment of the present invention, the organic electronic device may further comprise a hole blocking layer and an electron transport layer, wherein the hole blocking layer and the electron transport layer comprise an azine compound. Preferably, the azine compound is a triazine compound.

### Electron injection layer (EIL)

An optional EIL, which may facilitate injection of electrons from the cathode, may be formed on the ETL, preferably directly on the electron transport layer. Examples of materials for forming the EIL include lithium 8-hydroxyquinolinolate (LiQ), LiF, NaCl, CsF, Li2O, BaO, Ca, Ba, Yb, Mg which are known in the art. Deposition and coating conditions for forming the EIL are similar to those for formation of the HIL, although the deposition and coating conditions may vary, according to the material that is used to form the EIL.

The thickness of the EIL may be in the range from about 0.1 nm to about 10 nm, for example, in the range from about 0.5 nm to about 9 nm. When the thickness of the EIL is within this range, the EIL may have satisfactory electron-injecting properties, without a substantial penalty in driving voltage.

### Cathode layer

The cathode layer is formed on the ETL or optional EIL. The cathode layer may be formed of a metal, an alloy, an electrically conductive compound, or a mixture thereof. The cathode layer may have a low work function. For example, the cathode layer may be formed of lithium (Li), magnesium (Mg), aluminum (Al), aluminum (Al)-lithium (Li), calcium (Ca), barium (Ba), ytterbium (Yb), magnesium (Mg)-indium (In), magnesium (Mg)-silver (Ag), or the like. Alternatively, the cathode layer may be formed of a transparent conductive oxide, such as ITO or IZO.

The thickness of the cathode layer may be in the range from about 5 nm to about 1000 nm, for example, in the range from about 10 nm to about 100 nm. When the thickness of the cathode layer is in the range from about 5 nm to about 50 nm, the cathode layer may be transparent or semitransparent even if formed from a metal or metal alloy.

It is to be understood that the cathode layer is not part of an electron injection layer or the electron transport layer.

### Organic electronic device

According to one embodiment of the organic electronic device, wherein the hole injection layer may be arranged in direct contact with the anode layer comprising at least a first anode sub-layer and a second anode sub-layer.

According to one embodiment of the present invention, wherein the organic electronic device may comprise the hole injection layer comprising the metal complex of formula (I) or formula (Ia) and the compound of formulae (III) or (IV), wherein in formula (I) or formula (Ia) M is selected from Li, Na, K, Cs, Mg, Mn, Cu, Zn or Ag,, alternatively Mg, Mn, Cu, Zn or Ag, , alternatively Cu, Zn or Ag.

According to another embodiment, wherein the organic electronic device can be a light emitting device or a display device.

According to one aspect of the present invention, there is provided an organic electronic device comprising: a substrate; an anode layer comprising at least two anode sublayers or more comprises at least a first anode sub-layer and a second anode sub-layer formed on the substrate; a hole injection layer comprising a metal complex of formula (I) or (Ia) and a compound of formulae (III) or (IV) according to invention, a hole transport layer, at least a first emission layer, an electron transport layer and a cathode layer.

According to another aspect of the present invention, there is provided an organic electronic device comprising: a substrate; an anode layer comprising at least two anode sublayers or more comprises a first anode sub-layer and a second anode sub-layer formed on the substrate; a hole injection layer comprising a compound of formulae (III) or (IV) and a metal complex of formula (I) or formula (Ia), a hole transport layer, an electron blocking layer, at least a first emission layer, a hole blocking layer, an electron transport layer and a cathode layer.

According to another aspect of the present invention, there is provided an organic electronic device comprising: a substrate; an anode layer comprising at least two anode sublayers or more comprising a first anode sub-layer and a second anode sub-layer formed on the substrate, a hole injection layer comprising a compound of formulae (III) or (IV) and a metal complex of formula (I) or formula (Ia), a hole transport layer, an electron blocking layer, at least a first emission layer, a hole blocking layer, an electron transport layer, an optional electron injection layer, and a cathode layer.

According to various embodiments of the present invention, there may be provided further layers arranged between the above-mentioned layers, on the substrate or on the top electrode.

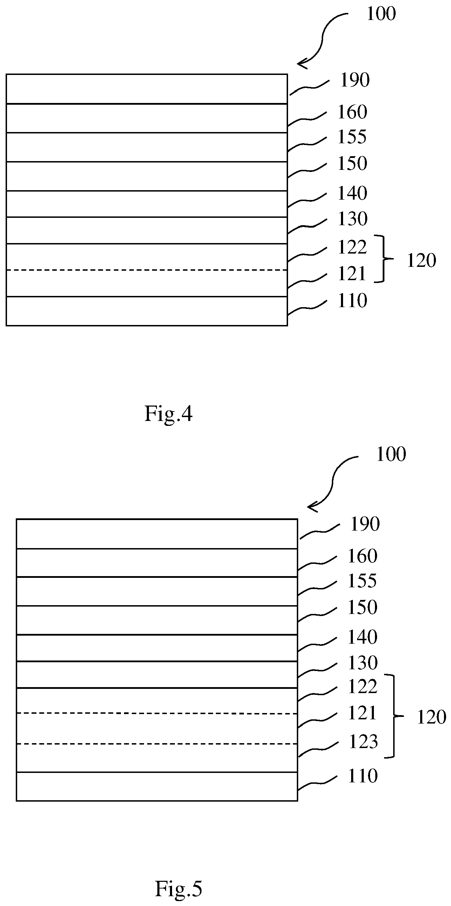

For example, the organic electronic device according to Fig. 5 may be formed by a process, wherein on a substrate (110), an anode layer (120) comprising at least a first anode sub-layer (121) and a second anode sub-layer (122), a hole injection layer (130) comprising a compound of formulae (III) or (IV) and metal complex of formula (I) or formula (Ia), a hole transport layer (140), a first emission layer (150), a hole blocking layer (155), an electron transport layer (160), and a cathode layer (190) are subsequently formed in that order.

### Method of manufacturing

According to another aspect of the present invention, there is provided a method of manufacturing an organic electronic device, the method using:
- at least one deposition source, preferably two deposition sources and more preferred at least three deposition sources.

The methods for deposition that can be suitable comprise:
- deposition via vacuum thermal evaporation;
- deposition via solution processing, preferably the processing may be selected from spin-coating, printing, casting; and/or
- slot-die coating.

According to various embodiments of the present invention, there is provided a method using:
- a first deposition source to release the compound of formulae (III) or (IV) according to the invention, and
- a second deposition source to release the metal complex of formula (I) or formula (Ia).
The method comprising the steps of forming the hole injection layer; whereby for an organic electronic device:
- the hole injection layer is formed by releasing the compound of formulae (III) or (IV) according to the invention from the first deposition source and the metal complex of formula (I) or formula (Ia) from the second deposition source.

According to various embodiments of the present invention, the method may further include forming the layers in the following order on the hole injection layer, at least one layer selected from the group consisting of forming a hole transport layer, forming a hole blocking layer, forming a first emission layer , forming a hole blocking layer, forming an electron transporting layer and/or forming an electron injection layer and/ or forming a cathode layer.

According to various embodiments of the present invention, the method may further include the steps for forming an organic electronic device, wherein
- on a substrate an anode layer comprising at least a first anode sub-layer and a second anode sub-layer is formed,
- on the anode layer comprising at least a first anode sub-layer and a second anode sub-layer a hole injection layer, which comprises a compound of formulae (III) or (IV) according to invention and a metal complex of formula (I) or formula (Ia) is formed,
- on the hole injection layer,a hole transport layer is formed,
- on the hole transport layer at least a first emission layer is formed,
- on the emission layer an electron transport layer is formed, optionally a hole blocking layer and/or an electron transport layer are formed on the emission layer,
- and finally, a cathode layer is formed,
- optional an electron blocking layer is formed in that order between the hole transport layer and the emission layer,
- optional an electron injection layer is formed between the electron transport layer and the cathode layer.

According to various embodiments, the organic electronic device may have the following layer structure, wherein the layers having the following order:
an anode layer comprising at least a first anode sub-layer and a second anode sub-layer, a hole injection layer comprising a compound of formulae (III) or (IV) according to the invention and a metal complex of formula (I) or formula (Ia), a hole transport layer, optional an electron blocking layer, at least a first emission layer, optional a hole blocking layer, an electron transport layer, optional an electron injection layer, and a cathode layer.

According to one embodiment, the organic electronic device of the present invention is formed by deposition of the hole injection layer in vacuum.

According to another aspect, it is provided an electronic device comprising at least one organic light emitting device according to any embodiment described throughout this application, preferably, the electronic device comprises the organic light emitting diode in one of embodiments described throughout this application. More preferably, the organic electronic device is a display device.

According to another aspect of the invention a metal complex for use in an organic electronic device or layer of an organic electronic device is provided, wherein the metal complex has the formula (I)

M^{n⊕}(L^{Θ})ₘ (I)

wherein
- M: is Ag(I) or Cu(II);
- n: is the valency of M;
- m: is n; and
- L: is selected from a compound of G7, G15, G17, G19, G20 or G21:

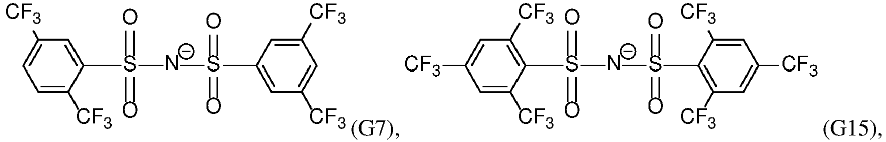

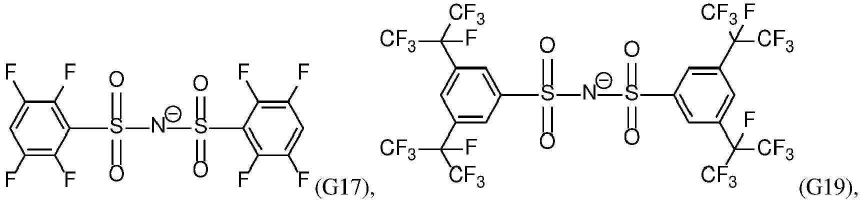

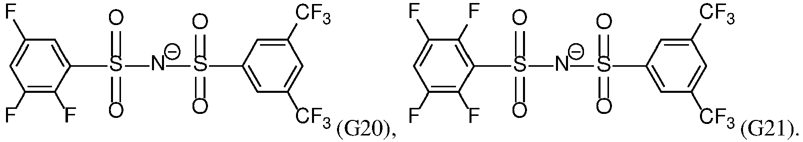

According to one aspect of the invention, M is Ag and n is 1 and/or M is Cu and n is 2; and L is selected from a compound of G7, G15, G17, G19, G20 or G21.

According to another aspect of the invention, M is Ag, n is 1 and L is selected from a compound of G7, G15, G17, G19, G20 or G21.

According to another aspect of the invention, M is Cu, n is 2 and L is selected from a compound of G7, G15, G17, G19, G20 or G21.

Hereinafter, the embodiments are illustrated in more detail with reference to examples. However, the present disclosure is not limited to the following examples. Reference will now be made in detail to the exemplary aspects.

### Description of the Drawings

The aforementioned components, as well as the claimed components and the components to be used in accordance with the invention in the described embodiments, are not subject to any special exceptions with respect to their size, shape, material selection and technical concept such that the selection criteria known in the pertinent field can be applied without limitations.

Additional details, characteristics and advantages of the object are disclosed in the dependent claims and the following description of the respective figures which in an exemplary fashion show preferred embodiments according to the invention. Any embodiment does not necessarily represent the full scope, however, and reference is made therefore to the claims and herein for interpreting the scope. It is to be understood that both the foregoing general description and the following detailed description are exemplary and explanatory only and are intended to provide further explanation of the present invention as claimed.

### Figures 1 to 7

- FIG. 1: is a schematic sectional view of an organic electronic device, according to an exemplary embodiment of the present invention;
- FIG. 2: is a schematic sectional view of an organic electronic device, according to an exemplary embodiment of the present invention;
- FIG. 3: is a schematic sectional view of an organic electronic device, according to an exemplary embodiment of the present invention.
- FIG. 4: is a schematic sectional view of an organic electronic device, according to an exemplary embodiment of the present invention;
- FIG. 5: is a schematic sectional view of an organic electronic device, according to an exemplary embodiment of the present invention;
- FIG. 6: is a schematic sectional view of an organic electronic device, according to an exemplary embodiment of the present invention;
- FIG. 7: is a schematic sectional view of an organic electronic device, according to an exemplary embodiment of the present invention.

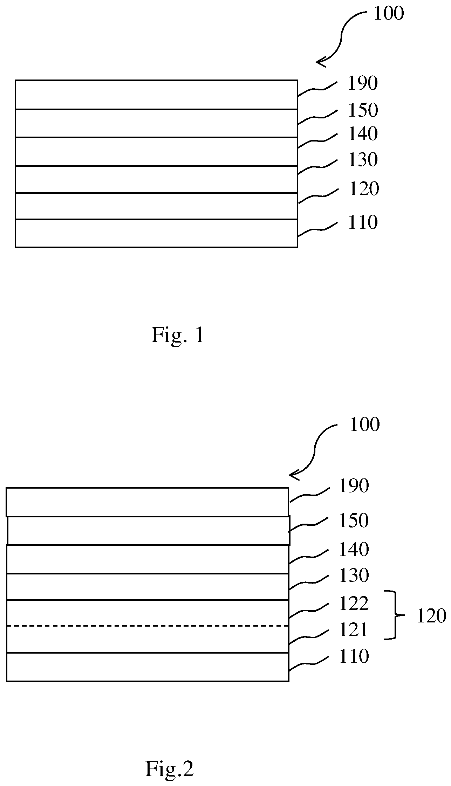

Hereinafter, the figures 1 to 7 are illustrated in more detail with reference to examples. However, the present disclosure is not limited to the following figures.

Herein, when a first element is referred to as being formed or disposed "on" or "onto" a second element, the first element can be disposed directly on the second element, or one or more other elements may be disposed there between. When a first element is referred to as being formed or disposed "directly on" or "directly onto" a second element, no other elements are disposed there between.

FIG. 1 is a schematic sectional view of an organic electronic device (100), according to an exemplary embodiment of the present invention. The organic electronic device (100) includes a substrate (110), an anode layer (120) and a hole injection layer (HIL) (130). The HIL (130) is disposed on the anode layer (120). Onto the HIL (130), a hole transport layer (140), a first emission layer (EML) (150), and a cathode layer (190) are disposed.

FIG. 2 is a schematic sectional view of an organic electronic device (100), according to an exemplary embodiment of the present invention. The organic electronic device (100) includes a substrate (110), an anode layer (120) that comprises a first anode sub-layer (121) and a second anode sub-layer (122), and a hole injection layer (HIL) (130). The HIL (130) is disposed on the anode layer (120) comprising a first anode sub-layer (121) and the second anode sub-layer (122) . Onto the HIL (130), a hole transport layer (140), a first emission layer (EML) (150), and a cathode layer (190) are disposed.

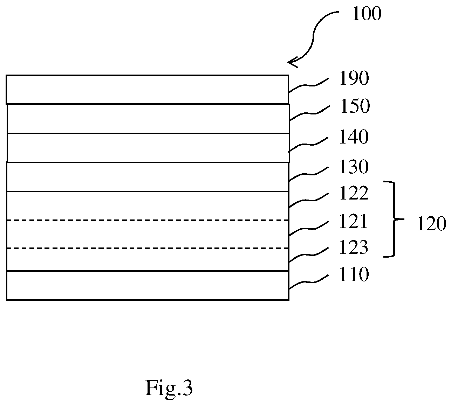

FIG. 3 is a schematic sectional view of an organic electronic device (100), according to an exemplary embodiment of the present invention. The organic electronic device (100) includes a substrate (110), an anode layer (120) that comprises a first anode sub-layer (121), a second anode sub-layer (122) and a third anode sub-layer (123), and a hole injection layer (HIL) (130). The HIL (130) is disposed on the anode layer (120). Onto the HIL (130), a hole transport layer (140), a first emission layer (EML) (150), and a cathode layer (190) are disposed.

FIG. 4 is a schematic sectional view of an organic electronic device (100), according to an exemplary embodiment of the present invention. The organic electronic device (100) includes a substrate (110), an anode layer (120) that comprises a first anode sub-layer (121) and a second anode sub-layer (122), and a hole injection layer (HIL) (130). The HIL (130) is disposed on the anode layer (120). Onto the HIL (130), an hole transport layer (HTL) (140), a first emission layer (EML) (150), a hole blocking layer (HBL) (155), an electron transport layer (ETL) (160), and a cathode layer (190) are disposed.

FIG. 5 is a schematic sectional view of an organic electronic device (100), according to an exemplary embodiment of the present invention. The organic electronic device (100) includes a substrate (110), an anode layer (120) that comprises a first anode sub-layer (121), a second anode sub-layer (122) and a third anode sub-layer (123), and a hole injection layer (HIL) (130). The HIL (130) is disposed on the anode layer (120). Onto the HIL (130), a hole transport layer (HTL) (140), a first emission layer (EML) (150), a hole blocking layer (HBL) (155), an electron transport layer (ETL) (160), and a cathode layer (190) are disposed.

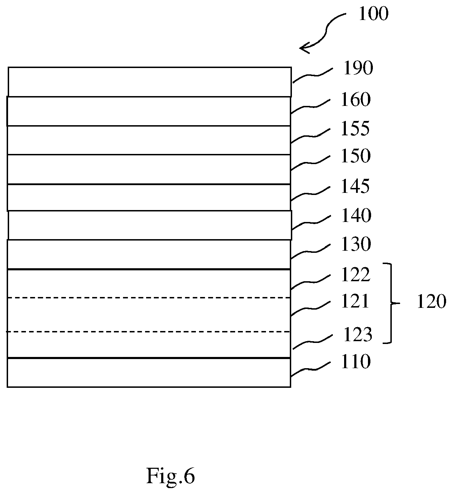

FIG. 6 is a schematic sectional view of an organic electronic device (100), according to an exemplary embodiment of the present invention. The organic electronic device (100) includes a substrate (110), an anode layer (120) that comprises a first anode sub-layer (121), a second anode sub-layer (122) and a third anode sub-layer (123), and a hole injection layer (HIL) (130). The HIL (130) is disposed on the anode layer (120). Onto the HIL (130), a hole transport layer (HTL) (140), an electron blocking layer (EBL) (145), a first emission layer (EML) (150), a hole blocking layer (HBL) (155), an electron transport layer (ETL) (160), and a cathode layer (190) are disposed.

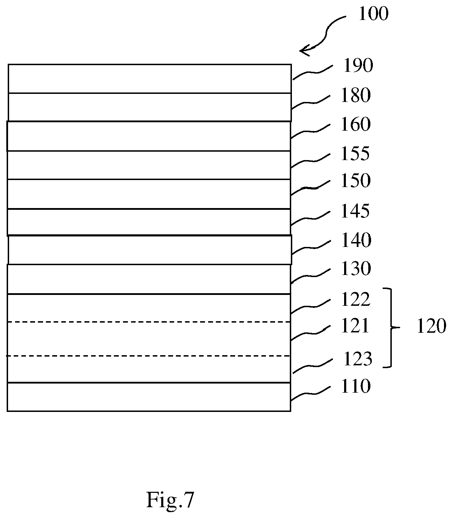

FIG. 7 is a schematic sectional view of an organic electronic device (100), according to an exemplary embodiment of the present invention. The organic electronic device (100) includes a substrate (110), an anode layer (120) that comprises a first anode sub-layer (121), a second anode sub-layer (122) and a third anode sub-layer (123), and a hole injection layer (HIL) (130). The HIL (130) is disposed on the anode layer (120). Onto the HIL (130), a hole transport layer (HTL) (140), an electron blocking layer (EBL) (145), a first emission layer (EML) (150), a hole blocking layer (HBL) (155), an electron transport layer (ETL) (160), an electron injection layer (180) and a cathode layer (190) are disposed.

While not shown in Fig. 1 to Fig. 7, a capping and/or a sealing layer may further be formed on the cathode layer 190, in order to seal the organic electronic device 100. In addition, various other modifications may be applied thereto.

Hereinafter, the embodiments are illustrated in more detail with reference to examples. However, the present disclosure is not limited to the following examples.

### Detailed description

The invention is furthermore illustrated by the following examples which are illustrative only and non-binding.

The metal complexes of formula (I) or formula (Ia) and compounds of formulae (III) or (IV) and may be prepared as described in the literature.

### Compounds of formula (I) and (la), wherein M is Ag(I):

In the following the preparation of several inventive compounds is shown, using the following General Method A:
The sulfonamide ligands were synthesized by methods known in the literature.

The sulfonamide ligand was dissolved in MeOH (ca. 5ml/g) and 0.55 eq Ag₂CO₃ were added. The reaction mixture was stirred overnight at room temperature. Excess silver carbonate was filtered off and washed with a small amount of methanol. The liquid phases were combined and the solvent was removed under reduced pressure. The remaining solid was dried in high vacuum. The crude material was purified by sublimation under reduced pressure.

### Compounds of formula (I) and (la), wherein M is Cu(II):

In the following the preparation of several inventive compounds is shown, using the following General Method B:
The sulfonamide ligands were synthesized by methods known in the literature.

The sulfonamide ligand was dissolved in water (ca 10ml/g) and 0.5 eq of Cu(OAc)2 was added. The mixture was stirred until a clear blue solution was obtained. The solvent was removed under reduced pressure. Residual acetic acid was removed by repeated adding of toluene and removal of the solvent under reduced pressure. The crude material was purified by sublimation.

### Rate onset temperature

The rate onset temperature (T_{RO}) is determined by loading 100 mg compound into a VTE source. As VTE source a point source for organic materials may be used as supplied by Kurt J. Lesker Com-pany (www.lesker.com) or CreaPhys GmbH (http://www.creaphys.com). The VTE source is heated at a constant rate of 15 K/min at a pressure of less than 10⁻⁵ mbar and the temperature inside the source measured with a thermocouple. Evaporation of the compound is detected with a QCM detector which detects deposition of the compound on the quartz crystal of the detector. The deposition rate on the quartz crystal is measured in Angstrom per second. To determine the rate onset temperature, the deposition rate is plotted against the VTE source temperature. The rate onset is the temperature at which noticeable deposition on the QCM detector occurs. For accurate results, the VTE source is heated and cooled three time and only results from the second and third run are used to determine the rate onset temperature.

To achieve good control over the evaporation rate of a compound, the rate onset temperature may be in the range of 200 to 300 °C. If the rate onset temperature is below 200 °C the evaporation may be too rapid and therefore difficult to control. If the rate onset temperature is above 300 °C the evaporation rate may be too low which may result in low tact time and decomposition of the metal complex in VTE source may occur due to prolonged exposure to elevated temperatures.

The rate onset temperature is an indirect measure of the volatility of a compound. The higher the rate onset temperature the lower is the volatility of a compound.

In Table 1 are shown rate onset temperatures T_{RO} for metal complexes of formula (I).

**Table 1: Metal complexes of formula (I)**

| Name | Chemical formula | T_{RO} (°C) |
|---|---|---|
| W1 | 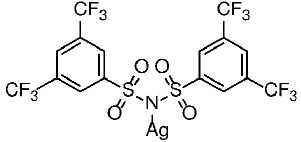 | 262 |
| W11 | 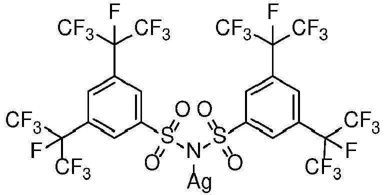 | 250 |
| W2 | 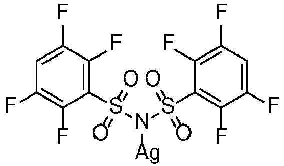 | 245 |
| W3 | 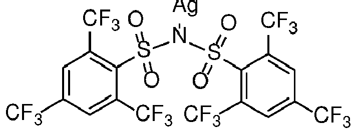 | 260 |
| W4 | 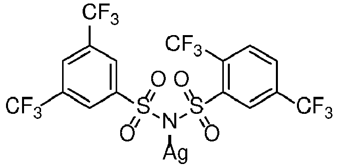 | 255 |
| W5 | 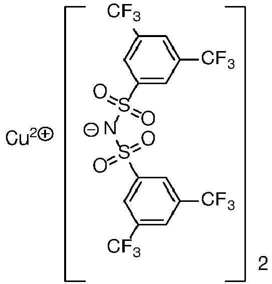 | 224 |
| W6 | 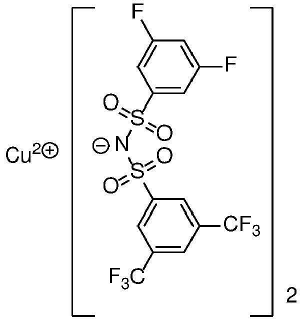 | 240 |
| W7 | 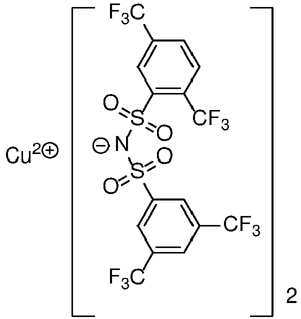 | 230 |
| W8 | 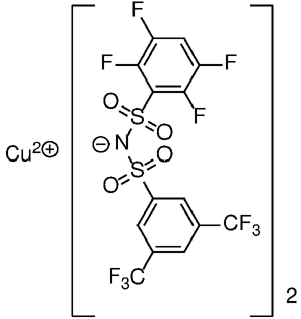 | 225 |
| W9 | 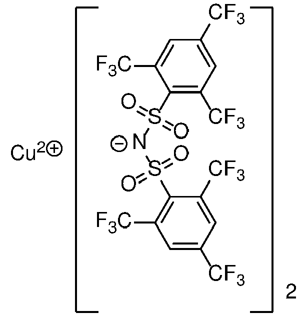 | 235 |
| W10 | 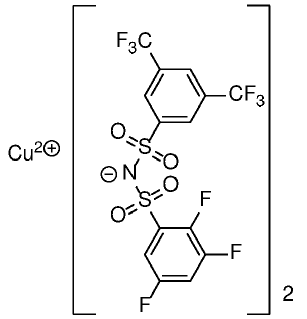 | 231 |

As can be seen in Table 1, the metal complexes of formula (I) have rate onset temperatures suitable for mass production of organic electronic devices.

### Calculated HOMO and LUMO

The HOMO and LUMO are calculated with the program package TURBOMOLE V6.5 (TURBOMOLE GmbH, Litzenhardtstrasse 19, 76135 Karlsruhe, Germany). The optimized geometries and the HOMO and LUMO energy levels of the molecular structures are determined by applying the hybrid functional B3LYP with a 6-31G* basis set in the gas phase. If more than one conformation is viable, the conformation with the lowest total energy is selected.

In Table 2 are shown the calculated HOMO levels and rate onset temperatures T_{RO} for matrix compounds of formula (I). HOMO levels were calculated as described above.

**Table 2: Calculated HOMO of compounds of formulae (III) or (IV)**

| | Chemical formula | Calculated HOMO (hybrid functional B3LYP and 6-31G* basis set in the gas phase) [eV] |
|---|---|---|
| F1 | 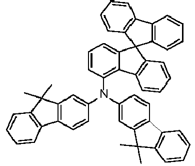 | - 4.800 |
| F2 | 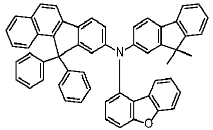 | - 4.800 |
| F3 | 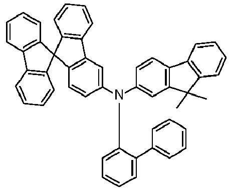 | - 4.800 |
| F4 | 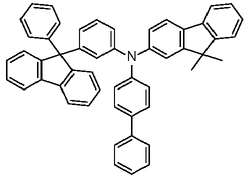 | - 4.806 |
| F5 | 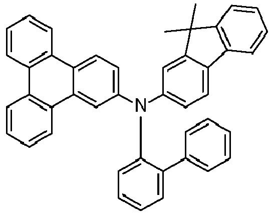 | - 4.816 |
| F6 | 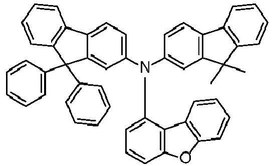 | - 4.818 |
| F7 | 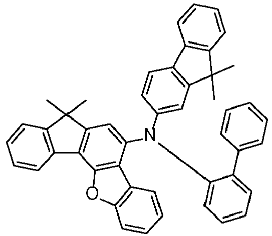 | - 4.822 |
| F8 | 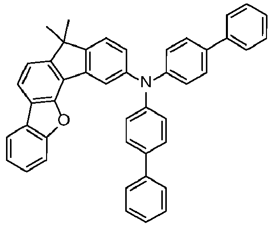 | - 4.822 |
| F9 | 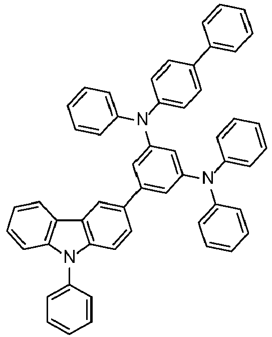 | - 4.825 |
| F10 | 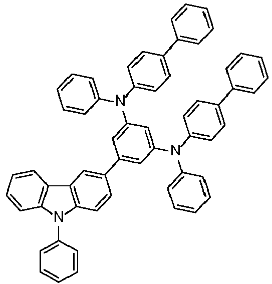 | - 4.832 |
| F11 | 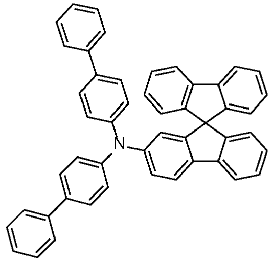 | - 4.854 |
| F12 | 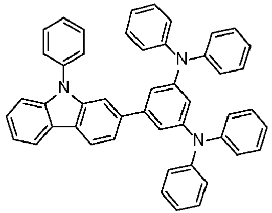 | - 4.876 |
| F13 | 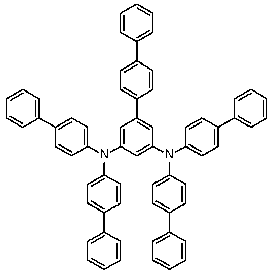 | - 4.884 |
| F14 | 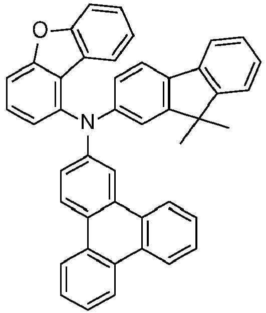 | - 4.904 |
| F15 | 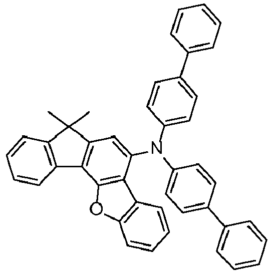 | - 4.904 |
| F16 | 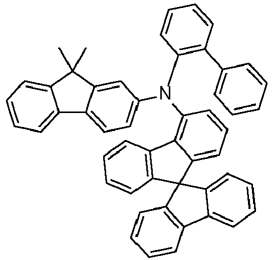 | - 4.927 |
| F17 | 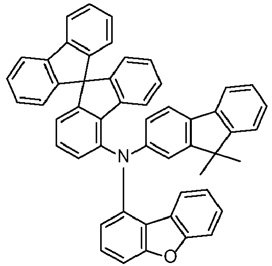 | - 4.928 |
| F18 | 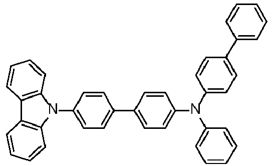 | - 4.960 |
| F19 | 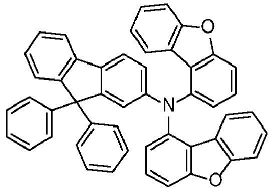 | - 4.967 |

### General procedure for fabrication of OLEDs

### General procedure for fabrication of organic electronic devices comprising a hole injection layer comprising a metal complex and a matrix compound

For Examples 1 to 27 and comparative examples 1 to 6 and in Table 3, a glass substrate with an anode layer comprising a first anode sub-layer of 120 nm Ag, a second anode sub-layer of 8 nm ITO and a third anode sub-layer of 10 nm ITO was cut to a size of 50 mm x 50 mm x 0.7 mm, ultrasonically washed with water for 60 minutes and then with isopropanol for 20 minutes. The liquid film was removed in a nitrogen stream, followed by plasma treatment to prepare the anode layer. The plasma treatment was performed in an atmosphere comprising 97.6 vol.-% nitrogen and 2.4 vol.-% oxygen at 80 W for 38 s.

Then, the compound of formulae (III) or (IV) and the metal complex of formula (I) were co-deposited in vacuum on the anode layer, to form a hole injection layer (HIL) having a thickness of 10 nm. The composition of the hole injection layer can be seen in Table 3.

Then, the compound of formulae (III) or (IV) was vacuum deposited on the HIL, to form a HTL. The compound of formulae (III) or (IV) in the HTL is selected the same as the compound of formulae (III) or (IV) in the HIL. The compound of formulae (III) or (IV) and the thickness of the HTL can be seen in Table 3. The thickness of the HTL is adjusted in such a way that the CIE 1931 y coordinate of the light emitted by the organic electronic device is in the range of 0.035 to 0.052.

Then N-(4-(dibenzo[b,d]furan-4-yl)phenyl)-N-(4-(9-phenyl-9H-fluoren-9-yl)phenyl)-[1,1'-biphenyl]-4-amine (CAS 1824678-59-2) was vacuum deposited on the HTL, to form an electron blocking layer (EBL) having a thickness of 5 nm.

Then 97 vol.-% H09 as EML host and 3 vol.-% BD200 (Sun Fine Chemicals, Korea) as fluorescent blue emitter dopant were deposited on the EBL, to form a blue-emitting first emission layer (EML) with a thickness of 20 nm.

Then a hole blocking layer (HBL) was formed with a thickness of 5 nm by depositing 2-(3'-(9,9-dimethyl-9H-fluoren-2-yl)-[1,1'-biphenyl]-3-yl)-4,6-diphenyl-1,3,5-triazine on the emission layer EML.

Then the electron transporting layer (ETL) having a thickness of 31 nm was formed on the hole blocking layer by depositing 50 wt.-% 4'-(4-(4-(4,6-diphenyl-1,3,5-triazin-2-yl)phenyl)naphthalen-1-yl)-[1,1'-biphenyl]-4-carbonitrile and 50 wt.-% of LiQ.

Then Yb was deposited on the ETL to form an electron injection layer (EIL) having a thickness of 2 nm.

Then Ag:Mg (90:10 vol.-%) was evaporated at a rate of 0.01 to 1 Å/s at 10⁻⁷ mbar to form a cathode layer with a thickness of 13 nm on the EIL.

Then, N-([1,1'-biphenyl]-4-yl)-9,9-dimethyl-N-(4-(9-phenyl-9H-carbazol-3-yl)phenyl)-9H-fluoren-2-amine was deposited on the cathode layer to form a capping layer with a thickness of 75 nm.

The OLED stack is protected from ambient conditions by encapsulation of the device with a glass slide. Thereby, a cavity is formed, which includes a getter material for further protection.

To assess the performance of the inventive examples compared to the prior art, the current efficiency is measured at 20°C. The current-voltage characteristic is determined using a Keithley 2635 source measure unit, by sourcing a voltage in V and measuring the current in mA flowing through the device under test. The voltage applied to the device is varied in steps of 0.1V in the range between 0V and 10V. Likewise, the luminance-voltage characteristics and CIE coordinates are determined by measuring the luminance in cd/m² using an Instrument Systems CAS-140CT array spectrometer (calibrated by Deutsche Akkreditierungsstelle (DAkkS)) for each of the voltage values. The cd/A efficiency at 10 mA/cm² is determined by interpolating the luminance-voltage and current-voltage characteristics, respectively.

To determine the EQE in % the light output of the device is measured using a calibrated photodiode at 15 mA/cm².

Lifetime LT of the device is measured at ambient conditions (20°C) and 30 mA/cm², using a Keithley 2400 sourcemeter, and recorded in hours.

The brightness of the device is measured using a calibrated photo diode. The lifetime LT is defined as the time till the brightness of the device is reduced to 97 % of its initial value.

To determine the voltage stability over time U(50h-1h), a current density of at 30 mA/cm² was applied to the device. The operating voltage was measured after 1 hour and after 50 hours, followed by calculation of the voltage stability for the time period of 1 hour to 50 hours. The higher the absolute value of U(50h-1h), the worse the voltage stability over time.

### Technical Effect of the invention

In Table 3 are shown data for organic electronic devices comprising a hole injection layer comprising a variety of metal complexes of formula (I) and a variety of compounds of formulae (III) or (IV) .

In comparative examples 1 and 2, the hole injection layer comprises metal complex LiTFSI (also named Lithium bis(trifluoromethanesulfonyl)imide). LiTFSI is free of substituents B¹ and B². The rate onset temperature of LiTFSI is 222 °C. The calculated HOMO of F1 is -4.8 eV, see Table 2. At 2 vol.-% doping concentration, the operating voltage is 4.3 V, the EQE efficiency is 12.37 %, the cd/A efficiency is 5.02 cd/A and the voltage stability over time U(50h-1h) is 0.741 V. At 4 vol.-% doping concentration, the operating voltage is improved to 4.06 V and the voltage stability over time is improved to 0.395 V. However, the efficiency is slightly reduced to 12.21 % and 4.94 cd/A, respectively.

In example 1, the hole injection layer comprises metal complex W1 at a concentration of 2 vol.-%. Compound of formulae (III) is the same as in comparative examples 1 and 2. The operating voltage is improved compared to comparative example 1. The efficiency is slightly lower at 11.97 %. However, the voltage stability over time is substantially improved to 0.69 V.

In examples 2 and 3, the hole injection layer comprises a higher concentration of W1. The operating voltage, efficiency and voltage stability over time are improved over comparative examples 1 to 3.

In examples 4 to 6, the hole injection layer comprises metal complex W5. The operating voltage, efficiency and/or voltage stability over time are improved over comparative examples 1 to 3.

In examples 7 to 12, the hole injection layer comprises compound of formula (III) F2. The calculated HOMO of F2 is -4.8 eV. As can be seen in Table 3, improved operating voltage, efficiency and/or voltage stability over time are improved over comparative examples 1 to 3.

In examples 13 to 18, the hole injection layer comprises compound of formula (III) F7. The calculated HOMO of F7 is -4.822 eV. As can be seen in Table 3, improved operating voltage, efficiency and/or voltage stability over time are improved over comparative examples 1 and 2. Additionally, the operating voltage and voltage stability over time are improved over comparative example 3. In comparative example 3, the metal complex of formula (I) has been replaced by LiTFSI.

In examples 19 to 21, the hole injection layer comprises compound of formula (III) F11. The calculated HOMO of F11 is -4.854 eV. As can be seen in Table 3, improved operating voltage, efficiency and/or voltage stability over time are improved over comparative example 4. In comparative example 4, the metal complex of formula (I) has been replaced by LiTFSI.

In examples 22 to 24, the hole injection layer comprises compound of formula (IV) F13. The calculated HOMO of F13 is -4.884 eV. As can be seen in Table 3, improved operating voltage, efficiency and/or voltage stability over time are improved over comparative example 5. In comparative example 5, the metal complex of formula (I) has been replaced by LiTFSI.

In examples 25 to 27, the hole injection layer comprises compound of formula (III) F16. The calculated HOMO of F13 is -4.927 eV. As can be seen in Table 3, improved operating voltage, efficiency and/or voltage stability over time are improved over comparative example 6. In comparative example 6, the metal complex of formula (I) has been replaced by LiTFSI.

In summary, a substantial improvement in performance, in particular operating voltage, efficiency and/or voltage stability over time, may be achieved in organic electronic devices according to invention.

In particular at a doping concentration of 2 vol.-% or less metal complex of formula (I), improved performance of examples according to invention may be obtained. A low doping concentration may be beneficial, as the metal complex of formula (I) may be deposited at a lower rate.

A reduction in operating voltage is beneficial for reduced power consumption and improved battery life, in particular in mobile devices.

An increase in EQE and/or cd/A efficiency is beneficial for reduced power consumption and improved battery life, in particular in mobile devices.

An improvement in voltage stability over time is beneficial for long-term stability of organic electronic devices.

**Table 3: Performance of an organic electronic device comprising a hole injection layer comprising a metal complex of formula (I) and a compound of formulae (III) or (IV)**

| | Metal complex of formula (I) | Concentration of metal complex of formula (I) (vol.-%) | Compound of formulae (III) or (IV) | Concentration of compound of formulae (III) or (IV) (vol.-%) | Thickness hole transport layer (nm) | Operating voltage U at 15 mA/cm² (V) | EQE at 15 mA/cm² (%) | cd/A efficiency at 15 mA/cm² (cd/A) | U(50h-1h) at 30 mA/cm² (V) |
|---|---|---|---|---|---|---|---|---|---|
| Comparative example 1 | LiTFSI | 2 | F1 | 98 | 123 | 4.30 | 12.37 | 5.02 | 0.741 |
| Comparative example 2 | LiTFSI | 4 | F1 | 96 | 123 | 4.06 | 12.21 | 4.94 | 0.395 |
| Example 1 | W1 | 2 | F1 | 98 | 123 | 4.08 | 11.97 | 4.96 | 0.069 |
| Example 2 | W1 | 4 | F1 | 96 | 123 | 3.89 | 12.04 | 4.98 | 0.035 |
| Example 3 | W1 | 8 | F1 | 92 | 123 | 3.77 | 12.57 | 5.15 | 0.030 |
| Example 4 | W5 | 2 | F1 | 98 | 123 | 3.86 | 12.14 | 5.03 | 0.290 |
| Example 5 | W5 | 4 | F1 | 96 | 123 | 3.78 | 12.61 | 5.20 | 0.065 |
| Example 6 | W5 | 8 | F1 | 92 | 123 | 3.78 | 12.48 | 5.14 | 0.027 |
| Example 7 | W1 | 2 | F2 | 98 | 126 | 3.69 | 13.02 | 6.84 | 0.001 |
| Example 8 | W1 | 4 | F2 | 96 | 126 | 3.62 | 12.96 | 6.78 | 0.011 |
| Example 9 | W1 | 8 | F2 | 92 | 126 | 3.61 | 12.83 | 6.71 | 0.007 |
| Example 10 | W5 | 2 | F2 | 98 | 126 | 3.63 | 12.84 | 6.52 | 0.133 |
| Example 11 | W5 | 4 | F2 | 96 | 126 | 3.62 | 12.70 | 6.54 | 0.020 |
| Example 12 | W5 | 8 | F2 | 92 | 126 | 3.62 | 12.69 | 6.51 | 0.014 |
| Example 13 | W1 | 2 | F7 | 98 | 127 | 3.99 | 14.25 | 6.05 | 0.121 |
| Example 14 | W1 | 4 | F7 | 96 | 127 | 3.87 | 14.40 | 6.08 | 0.037 |
| Example 15 | W1 | 8 | F7 | 92 | 127 | 3.82 | 14.91 | 6.25 | 0.020 |
| Example 16 | W5 | 2 | F7 | 98 | 127 | 3.83 | 15.81 | 8.15 | 0.229 |
| Example 17 | W5 | 4 | F7 | 96 | 127 | 3.82 | 15.56 | 7.94 | 0.045 |
| Example 18 | W5 | 8 | F7 | 92 | 127 | 3.82 | 15.64 | 7.90 | 0.029 |
| Comparative example 3 | LiTFSI | 4 | F7 | 96 | 127 | 3.96 | 15.56 | 7.43 | 0.278 |
| Example 19 | W1 | 4 | F11 | 96 | 124 | 3.62 | 12.33 | 5.84 | 0.047 |
| Example 20 | W1 | 8 | F11 | 92 | 124 | 3.61 | 12.33 | 5.59 | 0.039 |
| Example 21 | W1 | 12 | F11 | 88 | 124 | 3.61 | 12.32 | 5.91 | 0.039 |
| Comparative example 4 | LiTFSI | 4 | F11 | 96 | 124 | 3.88 | 12.19 | 5.77 | 0.194 |
| Example 22 | W1 | 4 | F13 | 96 | 125 | 3.73 | 13.12 | 7.07 | 0.184 |
| Example 23 | W1 | 8 | F13 | 92 | 125 | 3.71 | 13.15 | 7.06 | 0.124 |
| Example 24 | W1 | 12 | F13 | 88 | 125 | 3.72 | 13.12 | 7.06 | 0.12 |
| Comparative example 5 | LiTFSI | 4 | F13 | 96 | 125 | 4.15 | 12.97 | 6.64 | 0.756 |
| Example 25 | W1 | 4 | F16 | 96 | 127 | 3.92 | 12.15 | 5.15 | 0.085 |
| Example 26 | W1 | 8 | F16 | 92 | 127 | 3.80 | 12.03 | 5.08 | 0.082 |
| Example 27 | W1 | 12 | F16 | 88 | 127 | 3.79 | 12.00 | 5.03 | 0.073 |
| Comparative example 6 | LiTFSI | 4 | F16 | 96 | 127 | 4.55 | 11.70 | 4.84 | 0.587 |

The particular combinations of elements and features in the above detailed embodiments are exemplary only; the interchanging and substitution of these teachings with other teachings in this and the patents/applications incorporated by reference are also expressly contemplated. As those skilled in the art will recognize, variations, modifications, and other implementations of what is described herein can occur to those of ordinary skill in the art without departing from the spirit and the scope of the invention as claimed. Accordingly, the foregoing description is by way of example only and is not intended as limiting. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage. The invention's scope is defined in the following claims and the equivalents thereto. Furthermore, reference signs used in the description and claims do not limit the scope of the invention as claimed.

## Claims

1. An organic electronic device comprising a substrate, an anode layer, a cathode layer, at least one emission layer, and at least one or more hole injection layers, wherein the hole injection layer is arranged between the anode layer and the at least one emission layer, and wherein the hole injection layer comprises:
- a metal complex, wherein
the metal complex has the formula (I):
M^{n⊕}(L^{⊝}))ₘ (I)
wherein
M is a metal ion;
n is the valency of M;
m is n;
L is a ligand of formula (II) 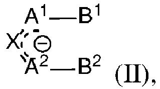
wherein
A¹ and A² are SO₂;
X is N;
B¹ and B² are independently selected from substituted C₆ to C₁₉ aryl or substituted or unsubstituted C₂ to C₂₀ heteroaryl,
wherein at least one of the substituents of the substituted C₆ to C₁₉ aryl or substituted C₂ to C₂₀ heteroaryl are independently selected from halogen, Cl, F, CN, partially or perfluorinated C₁ to C₈ alkyl, partially or perfluorinated C₁ to C₈ alkoxy;
and
- a compound of formulae (III) or (IV): 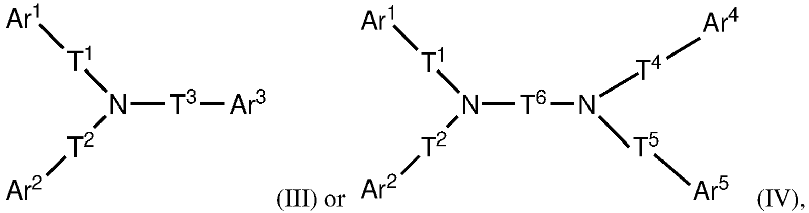 wherein
T¹, T², T³, T⁴ and T⁵ are independently selected from a single bond, phenylene, biphenylene, terphenylene or naphthenylene, preferably a single bond or phenylene;
T⁶ is selected from substituted or unsubstituted phenylene, biphenylene, terphenylene or naphthenylene, wherein the substituent on phenylene is selected from C₆ to C₁₈ aryl, C₃ to C₁₈ heteroaryl, phenyl, biphenyl, carbazole, phenyl carbazole, preferably biphenyl or 9-phenyl carbazole;
Ar¹, Ar², Ar³, Ar⁴ and Ar⁵ are independently selected from substituted or unsubstituted C₆ to C₂₀ aryl, or substituted or unsubstituted C₃ to C₂₀ heteroarylene, substituted or unsubstituted biphenylene, substituted or unsubstituted fluorene, substituted 9-fluorene, substituted 9,9-fluorene, substituted or unsubstituted naphthalene, substituted or unsubstituted anthracene, substituted or unsubstituted phenanthrene, substituted or unsubstituted pyrene, substituted or unsubstituted perylene, substituted or unsubstituted triphenylene, substituted or unsubstituted tetracene, substituted or unsubstituted tetraphene, substituted or unsubstituted dibenzofurane, substituted or unsubstituted dibenzothiophene, substituted or unsubstituted xanthene, substituted or unsubstituted carbazole, substituted 9-phenylcarbazole, substituted or unsubstituted azepine, substituted or unsubstituted dibenzo[b,f]azepine, substituted or unsubstituted 9,9'-spirobi[fluorene], substituted or unsubstituted 9,9'-spirobi[fluorene] with at least one fused aromatic ring, substituted or unsubstituted spiro[fluorene-9,9'-xanthene], a substituted or unsubstituted aromatic fused ring system comprising two aromatic 6-member rings and two aromatic 5-member rings, wherein at least one 5-member ring comprises a hetero atom, a substituted or unsubstituted or of aromatic fused ring system comprising two aromatic 6-member rings and two aromatic 5-member rings, wherein at least one 5-member ring comprises an O atom, or a substituted or unsubstituted aromatic fused ring system comprising at least three substituted or unsubstituted aromatic rings selected from the group comprising substituted or unsubstituted non-hetero, substituted or unsubstituted hetero 5-member rings, substituted or unsubstituted 6-member rings and/or substituted unsubstituted 7-member rings, substituted or unsubstituted fluorene, substituted or unsubstituted fluorene with an annelated substitued or unsubstitued hetero or non-hetero ring system comprising 2 to 6 substituted or unsubstituted 5-, 6- or 7-member rings, or a fused ring system comprising 2 to 6 substituted or unsubstituted 5- to 7-member rings and the rings are selected from the group comprising (i) unsaturated 5- to 7-member ring of a heterocycle, (ii) 5- to 6-member an aromatic heterocycle, (iii) unsaturated 5- to 7-member ring of a non-heterocycle, (iv) 6-member ring of an aromatic non-heterocycle;
wherein the substituents of Ar¹, Ar², Ar³, Ar⁴ and Ar⁵ are selected the same or different from the group comprising H, D, F, C(=O)R², CN, Si(R²)₃, P(=O)(R²)₂, OR², S(=O)R², S(=O)₂R², substituted or unsubstituted straight-chain alkyl having 1 to 20 carbon atoms, substituted or unsubstituted branched alkyl having 1 to 20 carbon atoms, substituted or unsubstituted cyclic alkyl having 3 to 20 carbon atoms, substituted or unsubstituted alkenyl or alkynyl groups having 2 to 20 carbon atoms, substituted or unsubstituted alkoxy groups having 1 to 20 carbon atoms, substituted or unsubstituted aromatic ring systems having 6 to 40 aromatic ring atoms, and substituted or unsubstituted heteroaromatic ring systems having 5 to 40 aromatic ring atoms, unsubstituted C₆ to C₁₈ aryl, unsubstituted C₃ to C₁₈ heteroaryl, a fused ring system comprising 2 to 6 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle,
wherein R² is selected from H, D, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, C₆ to C₁₈ aryl or C₃ to C₁₈ heteroaryl;
wherein the compound of formula (III) and (IV) has a calculated HOMO in the range of < -4.79 eV and > 6.5 eV.

2. An organic electronic device according to claim 1, wherein following compounds E1 to E5 are excluded:

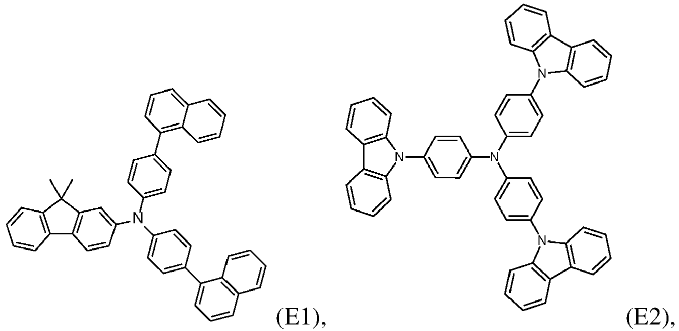

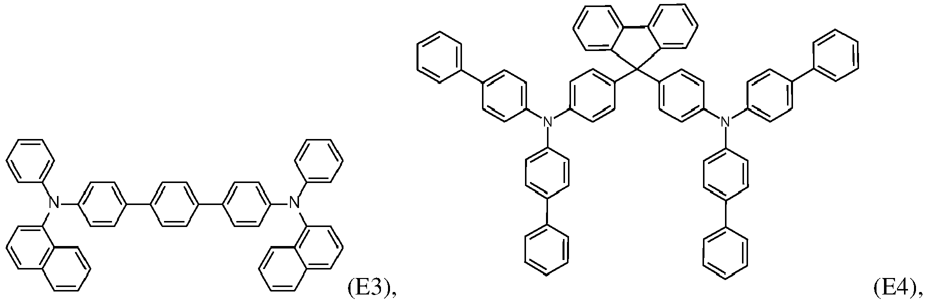

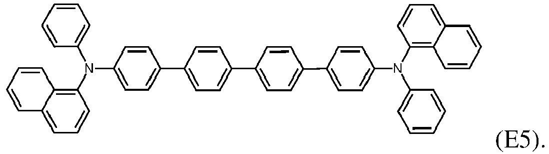

3. An organic electronic device according to claim 1 or 2, wherein the anode layer comprises a first anode sub-layer and a second anode sub-layer, wherein
- the first anode sub-layer comprises a first metal having a work function in the range of ≥ 4 and ≤ 6 eV, and
- the second anode sub-layer comprises a transparent conductive oxide, preferably TCO.

4. The organic electronic device according to any of claims 1 to 3, wherein M of the metal complex of formula (I) is selected from a metal ion wherein the corresponding metal has an electronegativity value according to Allen of less than 2.4, preferably M is selected from an alkali, alkaline earth, rare earth, transition metal, or group III or V metal, further preferred M is selected from a metal with an atomic mass ≥ 24 Da, in addition preferred M is selected from a metal with an atomic mass ≥ 24 Da and M has an oxidation number ≥ 2.

5. The organic electronic device according to any of preceding claims 1 to 4, wherein the metal complex of formula (I) has a molecular weight Mw of ≥ 339 and ≤ 2000 g/mol, preferably a molecular weight Mw of ≥ 400 and ≤ 1500 g/mol, further preferred a molecular weight Mw of ≥ 450 and ≤ 1500 g/mol, in addition preferred a molecular weight Mw of ≥ 450 and ≤ 1400 g/mol.

6. The organic electronic device according to any of preceding claims 1 to 5, wherein the anode layer of the organic electronic device comprises in addition a third anode sub-layer; wherein the third anode sub-layer comprises preferably a transparent conductive oxide, wherein the third anode sub-layer is arranged between the substrate and the first anode sub-layer.

7. The organic electronic device according to any of preceding claims 1 to 6, wherein the compounds of formulae (III) and (VI) have a molecular weight Mw of ≥ 400 and ≤ 2000 g/mol, preferably a molecular weight Mw of ≥ 450 and ≤ 1500 g/mol, further preferred a molecular weight Mw of ≥ 500 and ≤ 1000 g/mol, in addition preferred a molecular weight Mw of ≥ 550 and ≤ 900 g/mol.

8. The organic electronic device according to any of preceding claims 1 to 7, wherein Ar¹, Ar², Ar³, Ar⁴ and Ar⁵ are independently selected from D1 to D22: 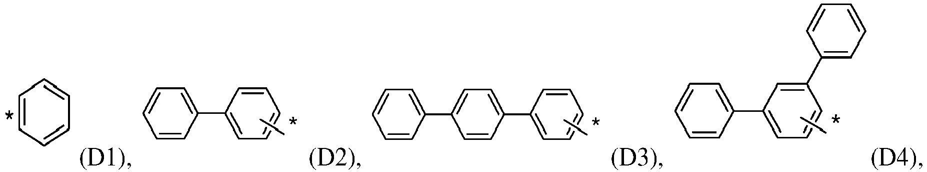 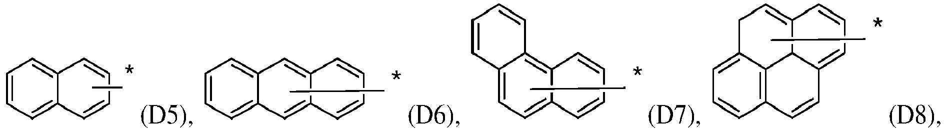 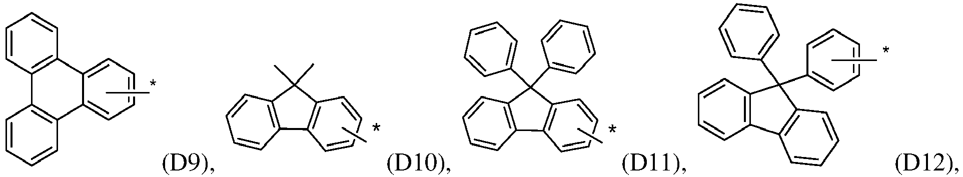 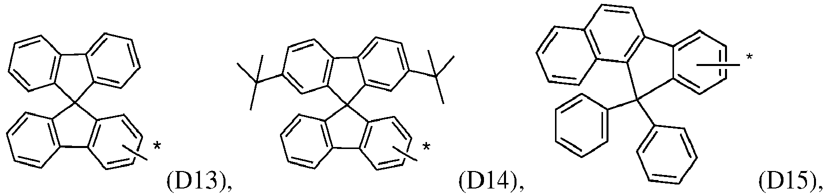 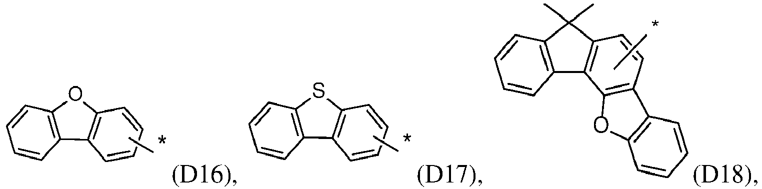 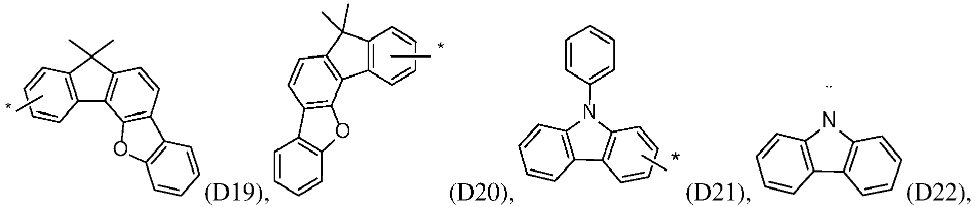 wherein the asterix "*" denotes the binding position.

9. The organic electronic device according to any of preceding claims 1 to 8, wherein the compounds of formulae (III) and (IV) are selected from F1 to F19:

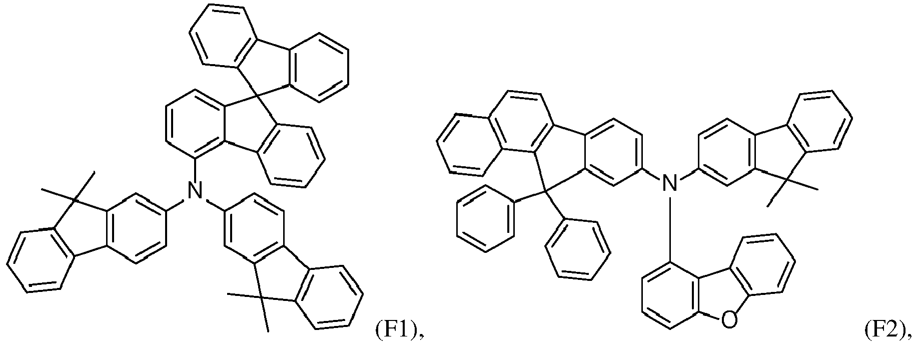

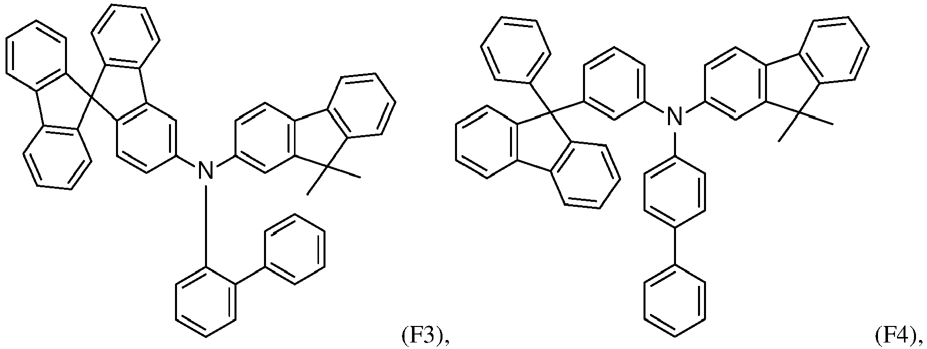

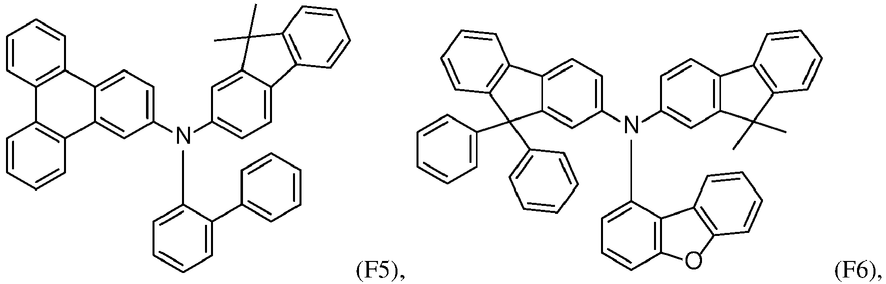

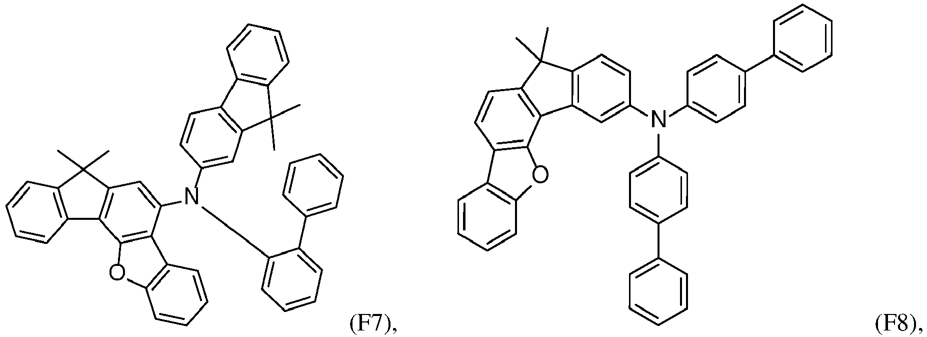

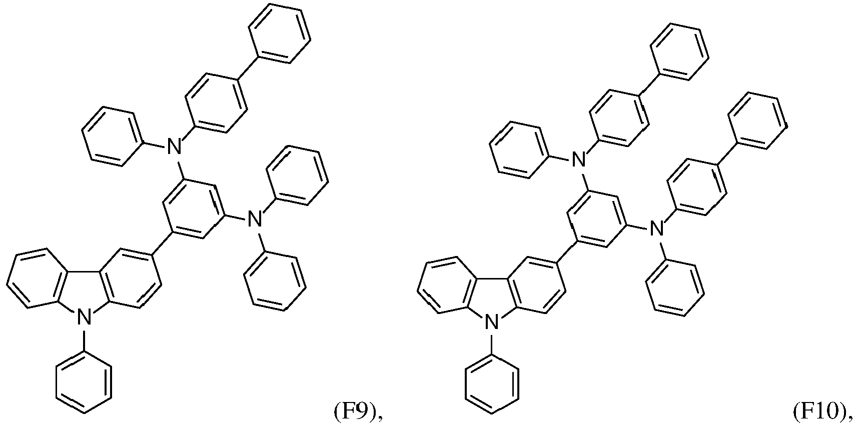

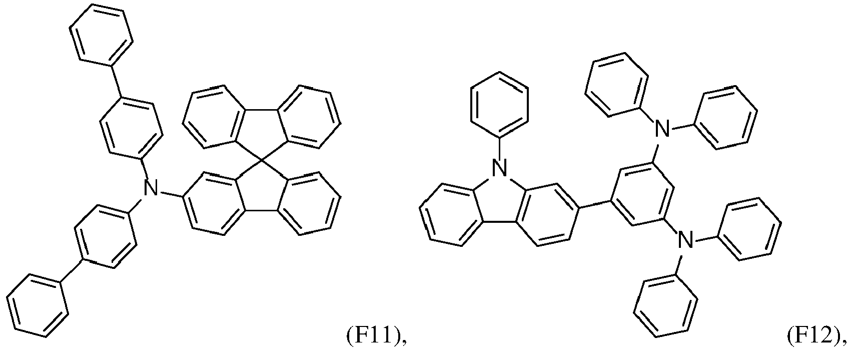

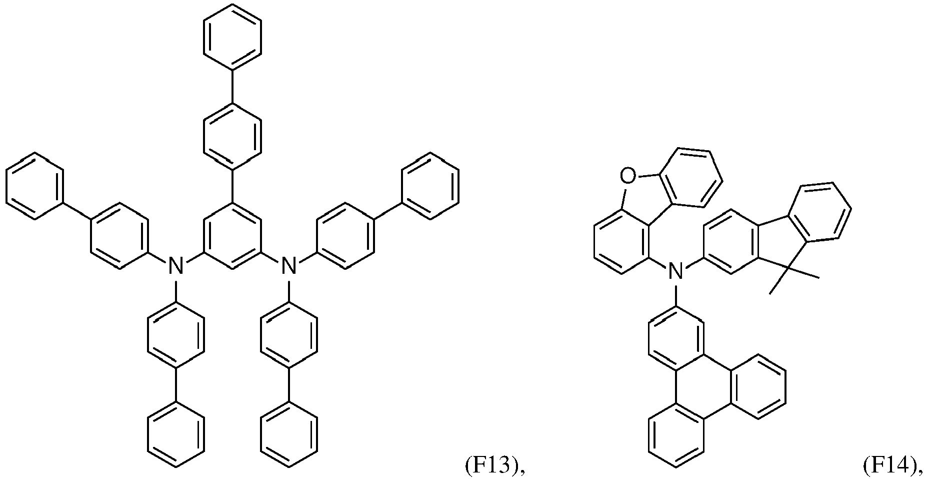

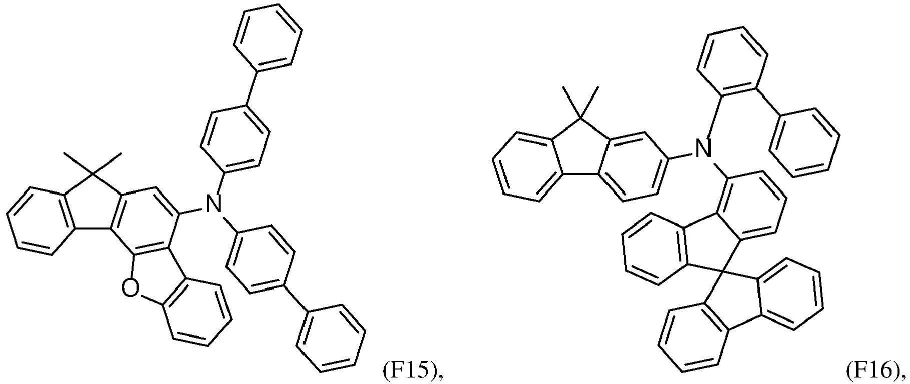

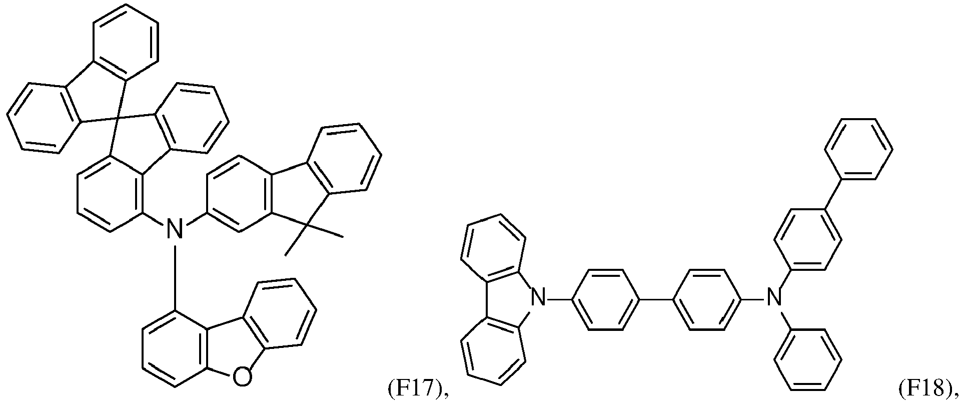

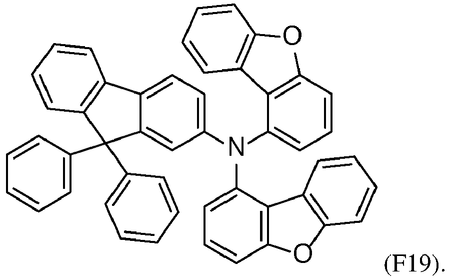

10. The organic electronic device according to any of the preceding claims 1 to 9, wherein m and n in formula (I) are the same and an integer from 1 to 4, preferably 1 to 3, also preferred 2 or 3.

11. The organic electronic device according to any of the preceding claims 1 to 10, wherein the metal complex is selected from the formula (Ia): 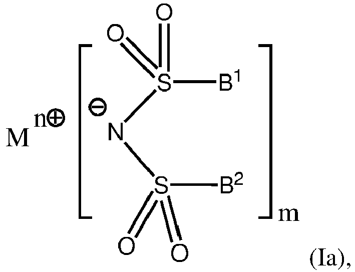 wherein
M is a metal ion;
n is the valency of M;
m is n;
B¹ and B² are independently selected from substituted C₆ to C₁₉ aryl or substituted or unsubstituted C₂ to C₂₀ heteroaryl,
wherein at least one of the substituents of the substituted C₆ to C₁₉ aryl or substituted C₂ to C₂₀ heteroaryl are independently selected from halogen, Cl, F, CN, partially or perfluorinated C₁ to C₈ alkyl, partially or perfluorinated C₁ to C₈ alkoxy.

12. The organic electronic device according to any of the preceding claims 1 to 11, wherein at least one or both of the groups B¹ and B² comprises each at least 1 to 5 substituents, preferably substituents 2 to 4 or 3 substituents, independently selected from halogen, F, CF₃, C₂F₅, C₃F₇, C₄F₉, OCF₃, OC₂F₅, or CN.

13. The organic electronic device according to any of the preceding claims 1 to 12, wherein the ligand L of formula (II) is independently selected from G1 to G21:

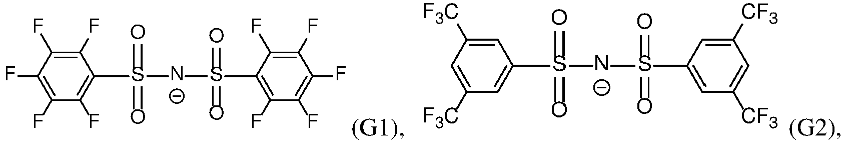

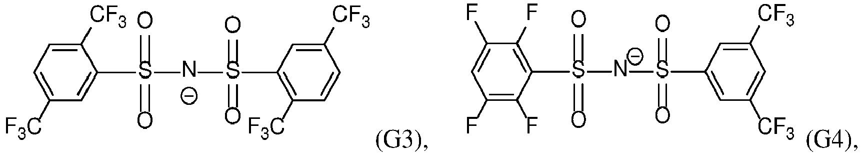

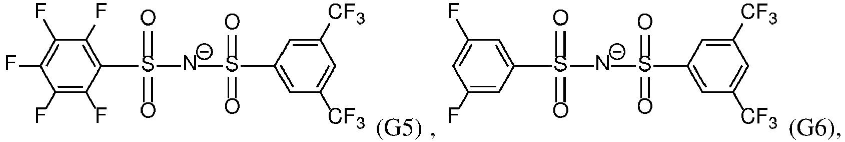

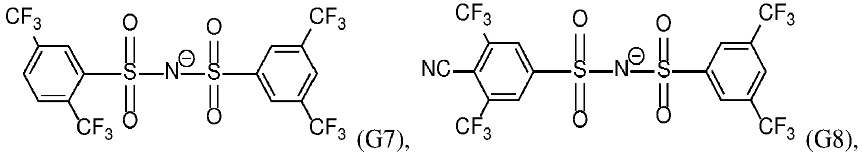

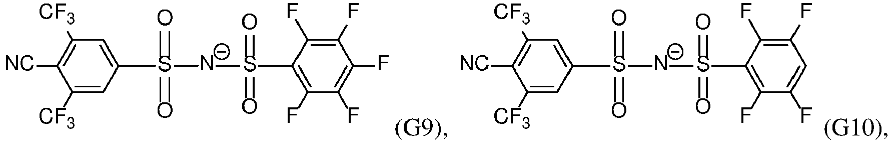

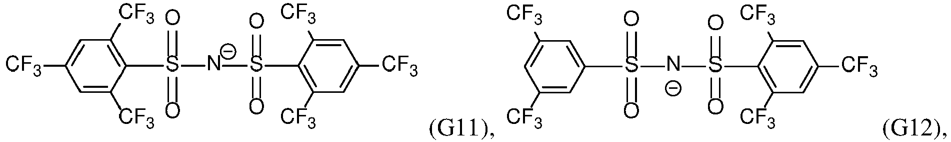

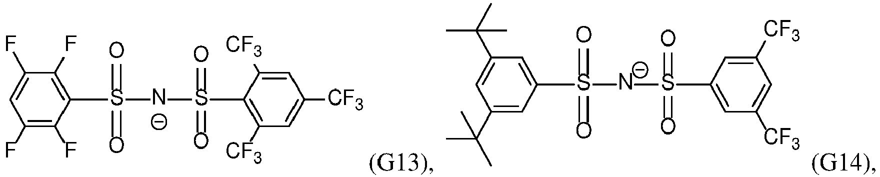

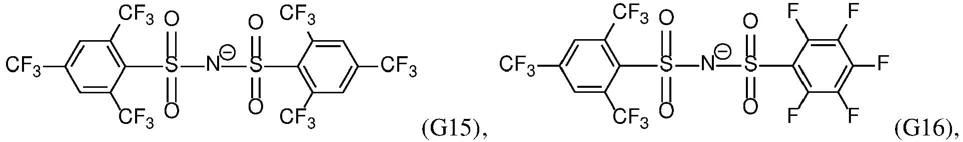

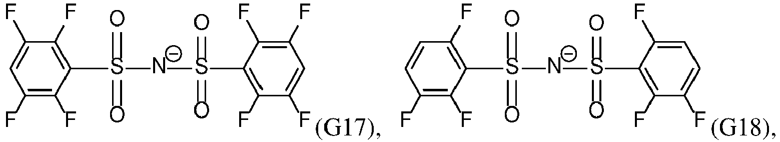

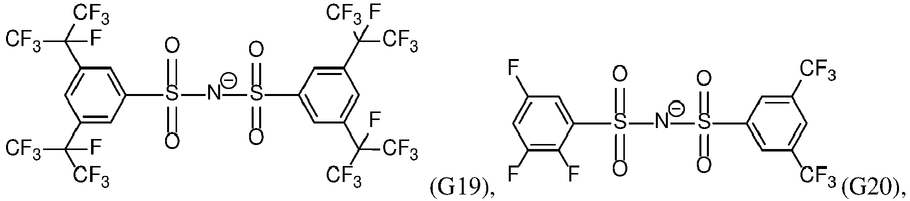

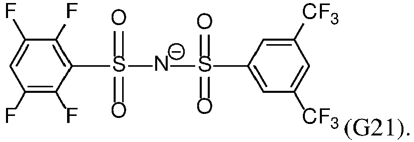

14. The organic electronic device according to any of the preceding claims 1 to 13, wherein the metal complex of Formula (I) is selected from a compound W1 to W11:

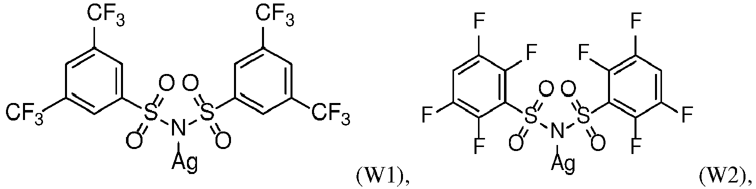

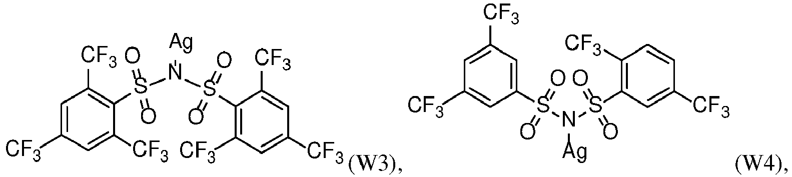

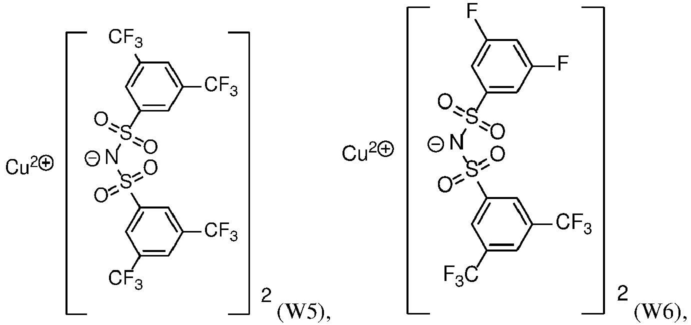

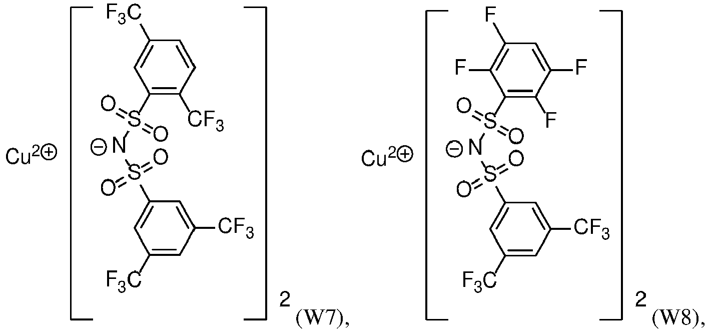

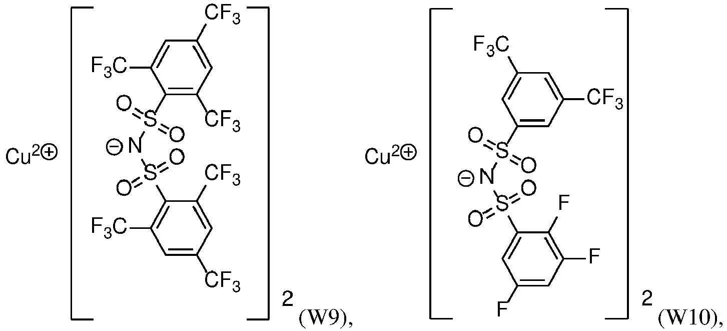

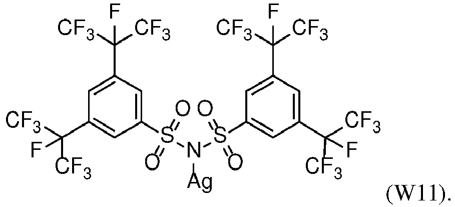

15. The organic electronic device according to any of preceding claims 1 to 14, wherein the organic electronic device further comprises a hole transport layer, wherein the hole transport layer is arranged between the hole injection layer and the at least one emission layer or first emission layer.

16. The organic electronic device according to claim 15, wherein the hole transport layer comprises a matrix compound according to formulae (III) or (IV), preferably the matrix compound in the hole injection layer and hole transport layer are selected the same.

17. The organic electronic device according to any of the preceding claims 1 to 16, wherein the organic electronic device is a light emitting device or a display device.

18. A metal complex for use in an organic electronic device or layer of an organic electronic device, wherein the metal complex has the formula (I)
M^{n⊕}(^{L⊝})m (I)
wherein
M is Ag(I) or Cu(II);
n is the valency of M;
m is n; and
L is selected from a compound of G7, G15, G17, G19, G20 or G21:
